# EUROPEAN PATENT APPLICATION

(11) **EP 4 183 547 A1**
(43) Date of publication of application: **24.05.2023**
(21) Application number: 21843075.9
(22) Date of filing: 13.07.2021
(51) Int. Cl.: B29C 45/14, H01L 23/473, H01M 10/613, H01M 10/625, H01M 10/6556, H01M 10/6568, F16J 15/06, H05K 7/20

(54) **HEAT EXCHANGER AND METHOD FOR MANUFACTURING HEAT EXCHANGER**

(30) Priority: 14.07.2020 JP 2020120925; 14.07.2020 JP 2020120926
(71) Applicant: Mitsui Chemicals, Inc., Tokyo 104-0028 (JP)
(72) Inventor: TOMINAGA, Takahiro, Sodegaura-shi, Chiba 299-0265 (JP); KIMURA, Kazuki, Sodegaura-shi, Chiba 299-0265 (JP)
(74) Representative: J A Kemp LLP
(86) International application number: PCT/JP2021/026321
(87) International publication number: WO 2022/014598

(57) **Abstract**

A heat exchange device includes a heat exchange main body portion, a joint member, and a resin sealing portion. The heat exchange main body portion has an internal flow path through which a heat exchange medium flows, and a metal wall portion including a through-hole communicating with the internal flow path. The joint member has a protruding portion and a hollow portion. The protruding portion includes an opening through which the heat exchange medium is supplied or discharged. The protruding portion protrudes toward an outside of the heat exchange main body portion through the through-hole. The hollow portion is formed for causing the opening and the internal flow path to communicate with each other. The resin sealing portion seals a gap between an inner peripheral surface of the through-hole and an outer peripheral surface of the protruding portion.

## Description

### Technical Field

The present invention relates to a heat exchange device and a method for manufacturing the heat exchange device.

### Background Art

A central processing unit (CPU) mounted on a computer or a secondary battery mounted on an electric vehicle generates heat during operation. As means for cooling such a heating element, various cooling devices that use a cooling medium have been proposed.

Patent Document 1 discloses a water-cooled plate-type cooling unit. The cooling unit disclosed in Patent Document 1 includes a pair of plates, a rib, and a water supply/discharge fitting. The rib defines a flow path in a cavity region between the pair of plates. An external hose is coupled to the water supply/discharge fitting. A heat transfer medium flows into or is discharged into the flow path via the water supply/discharge fitting. The pair of plates, the rib, and the water supply/discharge fitting are made of metal. The water supply/discharge fittings and the rib are welded to the pair of plates.

Patent Document 1: Japanese Patent Application Laid-Open (JP-A) No. 2015-210032

### SUMMARY OF INVENTION

### Technical Problem

In response to diversification of applications of cooling devices in recent years, it is desired to cope with weight reduction, cost reduction, and the like of cooling devices as well as complication of a shape. In particular, in a cooling device using a cooling medium, a technique for joining a joint member or a first member for water supply and discharge to a heat exchange main body portion such as a pair of plates by a method other than welding or brazing while ensuring airtightness is required.

In view of the above circumstances, an object of the present disclosure is to provide a heat exchange device having excellent airtightness even when the joint member or the first member is not welded or brazed, and a method for manufacturing the heat exchange device.

Another object of the disclosure is to provide a heat exchange device capable of configuring a degree of freedom in designing an internal flow path through which a heat exchange medium flows.

### Solution to Problem

Means for solving the above problems include the following embodiments.

<1> A heat exchange device according to a first aspect of the disclosure includes: a heat exchange main body portion that has an internal flow path through which a heat exchange medium flows and a metal wall portion including a through-hole that communicates with the internal flow path; a joint member that has a protruding portion including an opening through which the heat exchange medium is supplied or discharged and protruding toward an outside of the heat exchange main body portion via the through-hole, and a hollow portion for causing the opening and the internal flow path to communicate with each other; and a resin sealing portion that seals a gap between an inner peripheral surface of the through-hole and an outer peripheral surface of the protruding portion.

The heat exchange device according to the first aspect can prevent leakage of the heat exchange medium or intrusion of foreign matter from an outside through the gap between the through-hole and the protruding portion. That is, the heat exchange device of the first aspect has excellent airtightness even when the joint member is not joined to the heat exchange main body portion by brazing or welding.

<2> A heat exchange device according to a second aspect of the disclosure includes: a heat exchange main body portion that has a metal wall portion including a through-hole; a first component that covers the through-hole; and a second component that is connected to the first component, in which the heat exchange main body portion further has an internal flow path through which a heat exchange medium flows, the first component has a first connecting portion including a first opening, and to which the second component is connected, a first hollow portion for causing the first opening and the internal flow path to communicate with each other, and a resin fixing portion that is fixed to the metal wall portion, and the second component has a second connecting portion that includes a second opening through which the heat exchange medium is supplied or discharged, and to which a supply unit that supplies the heat exchange medium to the internal flow path or a discharge unit that discharges the heat exchange medium from the internal flow path is connected, and a second hollow portion that causes the second opening and the first opening to communicate with each other.

In the disclosure, "first component that covers the through-hole" includes a first aspect and a second aspect. The first aspect indicates an aspect in which the first connecting portion of the first component protrudes toward the outside of the heat exchange main body portion via the through-hole, and the resin fixing portion seals the gap between the inner peripheral surface of the through-hole and the outer peripheral surface of the first connecting portion. The second aspect indicates an aspect in which the first component covers the through-hole so that the through-hole is not exposed, and there is no gap between the resin fixing portion and the metal wall portion.

The heat exchange device according to the second aspect can prevent leakage of the heat exchange medium or intrusion of foreign matter from the outside through the gap between the first component and the metal wall portion. That is, the heat exchange device of the second aspect has excellent airtightness even when the first component for supply and discharge is not joined to the heat exchange main body portion by brazing or welding.

<3> A heat exchange device according to a third aspect of the disclosure is the heat exchange device according to <2>, further including a packing that seals a gap between the first component and the second component.

The heat exchange device according to the third aspect can more reliably prevent leakage of the heat exchange medium or intrusion of foreign matter from the outside through the gap between the first component and the second component than a case where the packing is not provided.

<4> A heat exchange device according to a fourth aspect of the disclosure is the heat exchange device according to <2> or <3>, in which the first component includes a joint member, the joint member includes a protruding portion that is the first connecting portion and a hollow portion that is the first hollow portion, the joint member does not include a resin sealing portion that is the resin fixing portion, the protruding portion protrudes toward an outside of the heat exchange main body portion via the through-hole, and the resin sealing portion seals a gap between an inner peripheral surface of the through-hole and an outer peripheral surface of the protruding portion.

In the disclosure, "joint member does not include a resin fixing portion" indicates that the joint member and the resin fixing portion of the first component are separately formed, in other words, the joint member and the resin fixing portion are not integrally molded. In the disclosure, "protruding portion that is the first connecting portion" indicates that the first connecting portion is paraphrased as a protruding portion, "hollow portion that is the first hollow portion" indicates that the first hollow portion is paraphrased as a hollow portion, and "resin sealing portion that is the resin fixing portion" indicates that the resin fixing portion is paraphrased as a resin sealing portion.

The heat exchange device of the fourth aspect can prevent leakage of the heat exchange medium or intrusion of foreign matter from the outside through the gap between the through-hole and the first connecting portion. That is, the heat exchange device of the fourth aspect has excellent airtightness even when the joint member is not joined to the heat exchange main body portion by brazing or welding.

<5> A heat exchange device according to a fifth aspect of the disclosure is the heat exchange device according to <1> or <4>, in which the heat exchange main body portion has a facing wall portion facing the metal wall portion, the joint member has a projecting portion that projects from the outer peripheral surface of the protruding portion over an entire periphery of the outer peripheral surface of the protruding portion, and the projecting portion is in contact with an inner surface of the metal wall portion and an inner surface of the facing wall portion.

In the fifth aspect, the projecting portion functions as a support of the metal wall portion. Therefore, even when a pressing force is applied to the metal wall portion in a thickness direction of the metal wall portion, the metal wall portion is hardly deformed. For example, in a case where the resin sealing portion is formed by injection molding, the projecting portion serves as a support of the metal wall portion against an injection pressure, so that the metal wall portion is hardly deformed. As a result, the heat exchange device according to the fifth aspect can reduce a pressure loss of the heat exchange medium flowing through the internal flow path. That is, the heat exchange device according to the fifth aspect can efficiently allow the heat exchange medium to flow through the internal flow path.

<6> A heat exchange device according to a sixth aspect of the disclosure is the heat exchange device according to any one of <1>, <4>, and <5>, in which a surface of the metal wall portion in contact with the resin sealing portion is subjected to a roughening treatment.

In the sixth aspect, the surface of the metal wall portion in contact with the resin sealing portion includes fine unevenness. Accordingly, the resin sealing portion is firmly fixed to the metal wall portion by an anchor effect as compared with a case where the roughening treatment is not performed. As a result, the heat exchange device according to the sixth aspect can maintain airtightness for a long period of time.

<7> A heat exchange device according to a seventh aspect of the disclosure is the heat exchange device according to any one of <1> and <4> to <6>, in which the resin sealing portion has a covering portion that covers a periphery of the through-hole on an outer surface of the metal wall portion.

In the seventh aspect, a contact area between the resin sealing portion and the metal wall portion is larger than that in a case where the resin sealing portion does not have the covering portion. Therefore, the resin sealing portion is firmly fixed to the metal wall portion as compared with a case where the resin sealing portion does not have the covering portion. As a result, the heat exchange device according to the seventh aspect can maintain airtightness for a long period of time.

<8> A heat exchange device according to an eighth aspect of the disclosure is the heat exchange device according to <7>, in which the joint member has a projecting portion that projects from the outer peripheral surface of the protruding portion over an entire periphery of the outer peripheral surface of the protruding portion, and the covering portion has a first covering portion that covers a first region facing the projecting portion on the outer surface of the metal wall portion.

In the eighth aspect, even when the resin sealing portion is injection-molded and a thickness of the metal wall portion is relatively thin, occurrence of deformation of the metal wall portion due to the injection pressure is suppressed. Further, a contact area between the resin sealing portion and the metal wall portion is larger than a case where the resin sealing portion does not have the first covering portion. Therefore, the resin sealing portion is more firmly fixed to the metal wall portion. As a result, the heat exchange device according to the eighth aspect can maintain airtightness for a longer period of time.

<9> A heat exchange device according to a ninth aspect of the disclosure is the heat exchange device according to <8>, in which the covering portion has a second covering portion that covers a second region outside the first region of the outer surface of the metal wall portion with respect to the through-hole.

In the ninth aspect, the contact area between the resin sealing portion and the metal wall portion is larger than that in a case where the covering portion has only the first covering portion. Therefore, the resin sealing portion is more firmly fixed to the metal wall portion. As a result, the heat exchange device according to the ninth aspect can maintain airtightness for a longer period of time.

<10> A heat exchange device according to a tenth aspect of the disclosure is the heat exchange device according to any one of <7> to <9>, in which the outer peripheral surface of the protruding portion has a distal end side outer peripheral surface, a proximal end side outer peripheral surface having a diameter larger than that of the distal end side outer peripheral surface, and a step surface that couples the distal end side outer peripheral surface and the proximal end side outer peripheral surface, and the covering portion covers only the proximal end side outer peripheral surface of the outer peripheral surface of the protruding portion.

In the tenth aspect, when the resin sealing portion is formed by insert molding, which is a type of injection molding, the step surface can suppress formation of burrs. As a result, the heat exchange device of the tenth aspect is excellent in an appearance.

<11> A heat exchange device according to an eleventh aspect of the disclosure is the heat exchange device according to any one of <5> to <10>, in which the heat exchange main body portion has a facing wall portion facing the metal wall portion, the joint member has a projecting portion that projects from the outer peripheral surface of the protruding portion over an entire periphery of the outer peripheral surface of the protruding portion, the projecting portion has a notch portion that forms a flow path between the notch and an inner surface of the facing wall portion, and the flow path causes the hollow portion and the internal flow path to communicate with each other.

In the eleventh aspect, the joint member does not have the notch portion, and can form a passage for the heat exchange medium having a larger volume than a case where the hollow portion and the internal flow path directly communicate with each other. Therefore, a pressure loss of the heat exchange medium flowing through the internal flow path is reduced. As a result, the heat exchange device of the eleventh aspect can efficiently allow the heat exchange medium to flow through the internal flow path.

<12> A heat exchange device according to a twelfth aspect of the disclosure is the heat exchange device according to <11>, in which a cross-sectional shape of the notch portion is an arch shape.

In the twelfth aspect, even when a pressing force is applied to the metal wall portion in a thickness direction of the metal wall portion, the flow path is less likely to be deformed as compared with a case where the flow path does not have an arch shape. Therefore, the heat exchange device of the twelfth aspect can reduce the pressure loss of the heat exchange medium flowing through the internal flow path. As a result, the heat exchange device of the twelfth aspect can efficiently allow the heat exchange medium to flow through the internal flow path.

<13> A heat exchange device according to a thirteenth aspect of the disclosure is the heat exchange device according to any one of <1> and <4> to <12>, in which the outer peripheral surface of the protruding portion is made of a metal, and a surface of the outer peripheral surface of the protruding portion in contact with the resin sealing portion is subjected to a roughening treatment.

In the thirteenth aspect, the surface of the protruding portion in contact with the resin sealing portion includes fine unevenness. Therefore, the resin sealing portion is firmly fixed to the protruding portion by the anchor effect as compared with a case where the roughening treatment is not performed. As a result, the heat exchange device according to the thirteenth aspect can maintain airtightness for a longer period of time.

<14> A heat exchange device according to a fourteenth aspect of the disclosure is the heat exchange device according to any one of <1> and <4> to <12>, in which the outer peripheral surface of the protruding portion is made of a resin, and the outer peripheral surface of the protruding portion and the resin sealing portion are fused.

In the disclosure, "fused" means a state in which the outer peripheral surface of the protruding portion and the resin sealing portion are fixed to each other by heat without an adhesive, a screw, or the like.

In the fourteenth aspect, the resin sealing portion and the joint member are firmly fixed to each other. As a result, the heat exchange device of the fourteenth aspect can maintain airtightness for a longer period of time.

<15> A heat exchange device according to a fifteenth aspect of the disclosure is the heat exchange device according to any one of <1> and <4> to <14>, in which the resin sealing portion is formed by injection molding.

In the fifteenth aspect, the resin sealing portion enters into a gap of the fine uneven portions on the surface of the metal wall portion in contact with the resin sealing portion. Therefore, the resin sealing portion is firmly fixed to the metal wall portion. As a result, the heat exchange device of the fifteenth aspect can maintain airtightness for a longer period of time.

<16> A method for manufacturing a heat exchange device according to a sixteenth aspect of the disclosure further includes: a preparation step of preparing a j oint member having a protruding portion; an insert step of disposing the joint member inside a heat exchange main body portion having a metal wall portion including a through-hole and protruding the protruding portion toward an outside of the heat exchange main body portion via the through-hole; and a sealing step of forming the resin sealing portion in a gap between an inner peripheral surface of the through-hole and an outer peripheral surface of the protruding portion and sealing the gap.

In the disclosure, "disposing the joint member inside a heat exchange main body portion" indicates that a portion of the joint member is accommodated in the heat exchange main body portion.

In the sixteenth aspect, a heat exchange device having excellent airtightness can be obtained even when the joint member is not joined to the heat exchange main body portion by brazing or welding. The joint member is prepared in advance before the sealing step is executed. Therefore, the joint member can be molded into a more complicated shape than a case of resin molded in the sealing step. The complicated shape includes, for example, an undercut. Examples of the undercut include a packing groove and a connecting groove. Therefore, for example, a complicated connector such as a rotary connector can be connected to the protruding portion of the joint member in order to be connected to an external supply unit or an external discharge unit. The external supply unit supplies the heat exchange medium to the heat exchange device. The heat exchange medium is discharged from the heat exchange device to the external discharge unit. As a result, a heat exchange device that can be used in a wide variety of fields is obtained.

<17> A method for manufacturing a heat exchange device according to a seventeenth aspect of the disclosure is the method for manufacturing a heat exchange device according to <16>, in which the heat exchange main body portion has a pair of metal members facing each other, and a resin joint portion that joins the pair of metal members, one of the pair of metal members includes the metal wall portion, and in the sealing step, the resin sealing portion is formed and the resin joint portion is formed.

In the method for manufacturing a heat exchange device according to the seventeenth aspect, the resin sealing portion and the resin joint portion can be formed more efficiently than a case where the resin sealing portion and the resin joint portion are formed in separate steps.

<18> A method for manufacturing a heat exchange device according to an eighteenth aspect of the disclosure is the method for manufacturing a heat exchange device according to <16> or <17>, further including a roughening step of performing a roughening treatment on a surface of the metal wall portion with which the resin sealing portion is brought into contact, in which the roughening step is executed before the sealing step.

In the eighteenth aspect, before the sealing step is executed, a fine uneven structure is formed on a surface of the metal wall portion with which the resin sealing portion is brought into contact. Therefore, in the sealing step, for example, melt of the resin constituting the resin sealing portion easily enters the gap of the fine uneven structure. That is, by the anchor effect, the resin sealing portion that is firmly fixed to the metal wall portion is formed as compared with a case where the roughening treatment is not performed. As a result, a heat exchange device capable of maintaining airtightness for a long period of time is obtained.

<19> A heat exchange device according to a nineteenth aspect of the disclosure includes: a first metal plate having a through-hole; a second metal plate facing the first metal plate; a joint member that is sandwiched between the first metal plate and the second metal plate and to which a supply unit that supplies a heat exchange medium or a recovery unit that recovers the heat exchange medium is connected; and a resin fixing portion that is in contact with a peripheral edge portion of the first metal plate and the second metal plate and fixes the second metal plate to the first metal plate, in which the joint member includes: a recessed portion for forming an internal flow path through which the heat exchange medium flows with at least one of the first metal plate and the second metal plate, an opening exposed from the through-hole and for supplying or recovering the heat exchange medium, and a hollow portion for causing the opening and the internal flow path to communicate with each other.

In the nineteenth aspect, the internal flow path is formed even when a surrounding wall portion for forming the internal flow path is not machined and molded on at least one of the first metal plate or the second metal plate. In the heat exchange device according to the nineteenth aspect, by disposing a desired partition member in the internal flow path, a degree of freedom in designing the internal flow path through which the heat exchange medium flows can be easily improved.

<20> A heat exchange device according to a twentieth aspect of the disclosure is the heat exchange device according to <19>, further including a partition member that partitions the internal flow path, in which the partition member is disposed between the recessed portion and the second metal plate.

In the twentieth aspect, the internal flow path through which the heat exchange medium flows can be more freely designed.

<21> A heat exchange device according to a twenty-first aspect of the disclosure is the heat exchange device according to <19> or <20>, in which a gap is formed between the first metal plate and the second metal plate where the j oint member is not in contact with a peripheral edge portion of each of the first metal plate and the second metal plate, and the gap is filled with the resin fixing portion.

The heat exchange device of the twenty-first aspect can more reliably maintain airtightness for a long period of time.

<22> A heat exchange device according to a twenty-second aspect of the disclosure is the heat exchange device according to any one of <19> to <21>, in which the recessed portion forms the internal flow path with the second metal plate therebetween.

In the twenty-second aspect, the internal flow path can be formed even when the joint member is not molded into a complicated structure.

<23> A heat exchange device according to a twenty-third aspect of the disclosure is the heat exchange device according to any one of <19> to <22>, in which surfaces of the first metal plate and the second metal plate in contact with the resin fixing portion are subjected to a roughening treatment.

In the twenty-third aspect, the surfaces of the first metal plate and the second metal plate in contact with the resin fixing portion include fine unevenness. Accordingly, the resin fixing portion is firmly fixed to the first metal plate and the second metal plate by the anchor effect as compared with a case where the roughening treatment is not performed. As a result, the heat exchange device of the twenty-third aspect can maintain airtightness for a long period of time.

<24> A heat exchange device according to a twenty-fourth aspect of the disclosure is the heat exchange device according to any one of <19> to <23>, in which a material of the joint member is a resin, and the joint member and the resin fixing portion are fused.

In the twenty-fourth aspect, the resin fixing portion and the joint member are firmly fixed to each other. As a result, the heat exchange device of the twenty-fourth aspect can maintain airtightness for a longer period of time.

### Advantageous Effects of Invention

According to the disclosure, a heat exchange device having excellent airtightness even when a joint member is not welded or brazed, and a method for manufacturing the heat exchange device are provided.

According to the disclosure, there is provided a heat exchange device capable of improving a degree of freedom in designing an internal flow path through which a heat exchange medium flows.

### BRIEF DESCRIPTION OF DRAWINGS

Fig. 1 is a perspective view illustrating an appearance of a heat exchange device according to a first embodiment.
Fig. 2 is a perspective view illustrating an appearance of the heat exchange device according to the first embodiment.
Fig. 3 is a cross-sectional view taken along line III-III of Fig. 1.
Fig. 4 is an exploded perspective view of a heat exchange main body portion according to the first embodiment.
Fig. 5 is a perspective view illustrating an appearance of a joint member according to the first embodiment.
Fig. 6 is a cross-sectional view taken along line VI-VI of Fig. 5.
Fig. 7 is a cross-sectional view taken along line VII-VII of Fig. 1.
Fig. 8 is a top view of the heat exchange device according to the first embodiment.
Fig. 9 is an exploded perspective view of an insert according to the first embodiment.
Fig. 10 is a perspective view illustrating an appearance of a joint member according to a second embodiment.
Fig. 11 is a cross-sectional view of a heat exchange device according to the second embodiment.
Fig. 12 is a cross-sectional view of an insert according to the second embodiment in a state where an injection molding mold is clamped.
Fig. 13 is a perspective view illustrating an appearance of a joint member according to a third embodiment.
Fig. 14 is an exploded perspective view of a connector component and an O-ring attached to a heat exchange device according to the third embodiment.
Fig. 15 is a cross-sectional view taken along line XV-XV of Fig. 14.
Fig. 16 is a cross-sectional view of a heat exchange device according to a fourth embodiment.
Fig. 17 is a cross-sectional view of a heat exchange device according to a fifth embodiment.
Fig. 18 is a perspective view illustrating an appearance of an insert according to a sixth embodiment.
Fig. 19 is a perspective view illustrating an appearance of a joint member according to the sixth embodiment.
Fig. 20 is a top view of a joint member according to a sixth embodiment.
Fig. 21 is a perspective view illustrating an appearance of a heat exchange device according to the sixth embodiment.
Fig. 22 is a cross-sectional view taken along line XXII of Fig. 21.
Fig. 23 is a perspective view illustrating an appearance of a heat exchange device according to a seventh embodiment.
Fig. 24 is a perspective view illustrating an appearance of a heat exchange device according to an eighth embodiment.
Fig. 25 is a perspective view illustrating an appearance of a heat exchange device according to a ninth embodiment.
Fig. 26 is an exploded perspective view of a heat exchange device according to the ninth embodiment.
Fig. 27 is a perspective view illustrating an appearance of a heat exchange device according to the ninth embodiment.
Fig. 28 is a perspective view illustrating an appearance of a joint member according to the ninth embodiment.
Fig. 29 is a cross-sectional view taken along line XXIX-XXIX of Fig. 28.
Fig. 30 is a cross-sectional view taken along line XXX-XXX of Fig. 26.
Fig. 31 is a cross-sectional view taken along line XXXI-XXXI of Fig. 26.
Fig. 32 is a top view of a heat exchange device according to the ninth embodiment.
Fig. 33 is an exploded perspective view of an insert according to the ninth embodiment.
Fig. 34 is a cross-sectional view of an insert according to the ninth embodiment in a state where an injection molding mold is clamped.
Fig. 35 is a cross-sectional perspective view of a heat exchange device according to a tenth embodiment.
Fig. 36 is a cross-sectional perspective view of a heat exchange device according to an eleventh embodiment.
Fig. 37 is a cross-sectional perspective view of a heat exchange device according to a twelfth embodiment.
Fig. 38 is a cross-sectional perspective view of a heat exchange device according to a thirteenth embodiment.
Fig. 39 is a cross-sectional perspective view of a heat exchange device according to a fourteenth embodiment.
Fig. 40 is a cross-sectional perspective view of a heat exchange device according to a fifteenth embodiment.
Fig. 41 is a perspective view illustrating an appearance of an insert according to a sixteenth embodiment.
Fig. 42 is a perspective view illustrating an appearance of a joint member according to a seventeenth embodiment.
Fig. 43 is a top view of a joint member according to the seventeenth embodiment.
Fig. 44 is a perspective view illustrating an appearance of a heat exchange device according to the seventeenth embodiment from which a second component is removed.
Fig. 45 is a cross-sectional view taken along line XLV of Fig. 44.
Fig. 46 is a perspective view illustrating an appearance of a heat exchange device according to the seventeenth embodiment.
Fig. 47 is a perspective view illustrating an appearance of a heat exchange device according to an eighteenth embodiment.
Fig. 48 is a perspective view illustrating an appearance of a heat exchange device according to the eighteenth embodiment.
Fig. 49 is a cross-sectional view taken along line XLIX-XLIX of Fig. 47.
Fig. 50 is a cross-sectional view taken along line L-L of Fig. 47.
Fig. 51 is a perspective view illustrating an appearance of a second metal plate and a partition member according to the eighteenth embodiment.
Fig. 52 is a cross-sectional view of a modification of the heat exchange devices according to the first to eighth embodiments.

### DESCRIPTION OF EMBODIMENTS

Hereinafter, embodiments of a heat exchange device according to the disclosure will be described with reference to the drawings. In the drawings, the same or corresponding portions are denoted by the same reference numerals, and the description thereof will not be repeated.

### (1) First Embodiment

A heat exchange device 1A according to a first embodiment is used to promote heat dissipation of an external heating element. The heating element generates heat during operation. Examples of the heating element include a CPU and a secondary battery. Examples of the secondary battery include an on-vehicle lithium ion battery.

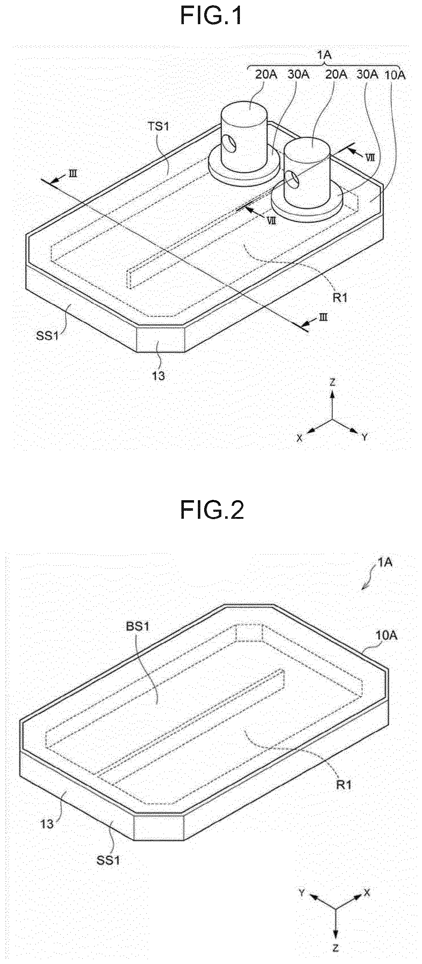

As illustrated in Fig. 1, the heat exchange device 1A includes a heat exchange main body portion 10A, a pair of joint members 20A, and a pair of resin sealing portions 30A. One of the pair of joint members 20A is for supply, and the other is for discharge. One of the pair of resin sealing portions 30A is for supply, and the other is for discharge. The joint member 20A is an example of a joint member. The resin sealing portion 30A is an example of a resin sealing portion.

In the first embodiment, a side on which the joint member 20A of the heat exchange device 1A is disposed is defined as a rear side of the heat exchange device 1A, and an opposite side is defined as a front side of the heat exchange device 1A. A right side when the heat exchange device 1A is viewed from the front side is defined as a right side of the heat exchange device 1A, and the opposite side is defined as a left side of the heat exchange device 1A. In a direction orthogonal to a front-rear direction and a left-right direction of the heat exchange device 1A, a side on which the joint member 20A is disposed is defined as an upper side of the heat exchange device 1A, and the opposite side is defined as a lower side of the heat exchange device 1A. Note that these orientations do not limit the orientation of the heat exchange device of the disclosure at the time of use.

In Figs. 1 to 24, the front side corresponds to a positive direction on an X-axis, the rear side corresponds to a negative direction on the X-axis, the right side corresponds to the positive direction on a Y-axis, the left side corresponds to the negative direction on the Y-axis, the upper side corresponds to the positive direction on a Z-axis, and the lower side corresponds to the negative direction on the Z-axis.

The heat exchange device 1A is of a plate type. The heat exchange device 1A has an upper main surface TS1. The joint member 20A and the resin sealing portion 30A are disposed on the upper main surface TS1 side of the heat exchange device 1A. As illustrated in Fig. 2, the heat exchange device 1A has a lower main surface BS1. The lower main surface BS1 of the heat exchange device 1A has a planar shape.

Dimensions of the heat exchange device 1A are not particularly limited, and can be selected according to an application or the like of the heat exchange device 1A. For example, an area of the lower main surface BS1 of the heat exchange device 1A may be within a range of 50 cm² to 5,000 cm². For example, a thickness of the heat exchange device 1A in a vertical direction may be within a range of 1 mm to 50 mm.

### (1.1) Heat Exchange Main Body Portion

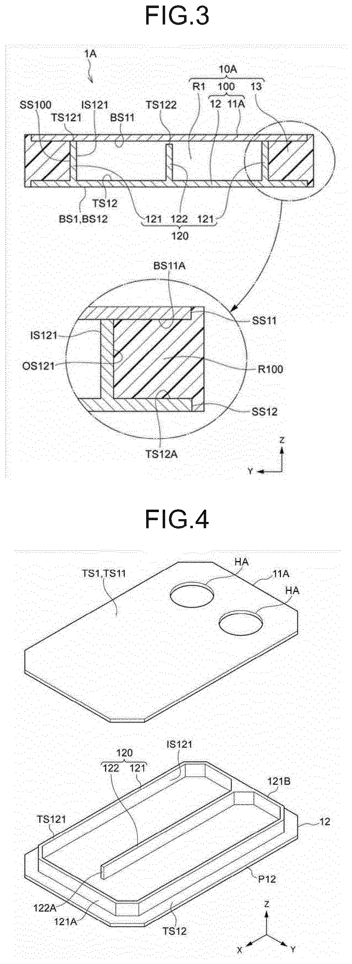

As illustrated in Fig. 3, the heat exchange main body portion 10A has an internal flow path R1, an upper metal member 11A, a lower metal member 12, and a resin joint portion 13. The upper metal member 11A is an example of one of the metal wall portion and the pair of metal members. The lower metal member 12 is an example of the other of the facing wall portion and the pair of metal members.

As illustrated in Figs. 1 to 3, the internal flow path R1 is located inside the heat exchange main body portion 10A. A cooling medium flows through the internal flow path R1. Examples of the cooling medium include a cooling liquid and a cooling gas. Examples of the cooling liquid include water and oil. Examples of the cooling gas include air and nitrogen gas. A temperature of the cooling medium is appropriately adjusted according to a type or the like of the heating element. The cooling medium is an example of a heat exchange medium.

As illustrated in Fig. 3, the upper metal member 11A has a lower main surface BS11. The lower metal member 12 has an upper main surface TS12. The lower main surface BS11 of the upper metal member 11A and the upper main surface TS12 of the lower metal member 12 face each other. The lower main surface BS11 of the upper metal member 11A is an example of an inner surface of the metal wall portion. The upper main surface TS12 of the lower metal member 12 is an example of an inner surface of the facing wall portion.

Hereinafter, a state in which the upper metal member 11A and the lower metal member 12 are overlapped such that the lower main surface BS11 and the upper main surface TS12 face each other may be referred to as an "overlapped body 100".

The resin joint portion 13 is formed over the entire periphery of a side surface SS100 of the overlapped body 100. In other words, as illustrated in Figs. 1 and 2, the resin joint portion 13 is formed over an entire periphery of a side surface SS1 of the heat exchange device 1A.

### (1.1.1) Upper Metal Member

As illustrated in Fig. 4, the upper metal member 11A is a flat plate-like object. The shape of the upper metal member 11A viewed from above to below is a substantially rectangular shape having a long side in the front-rear direction. The upper metal member 11A has an upper main surface TS11. The upper main surface TS11 constitutes a part of the upper main surface TS1 of the heat exchange device 1A. Each of the upper main surface TS11 and the lower main surface BS11 is planar. The upper main surface TS11 of the upper metal member 11A is an example of an outer surface of the metal wall portion.

The upper metal member 11A has a pair of through-holes HA. One of the pair of through-holes HA is for supply, and the other is for discharge.

The through-hole HA penetrates the upper metal member 11A along the vertical direction. The through-hole HA communicates with the internal flow path R1 (see Fig. 3) in the heat exchange device 1A. The joint member 20A is disposed in the through-hole HA. The shape of the through-hole HA viewed from above to below is circular.

The material of the upper metal member 11A is metal, and may be, for example, at least one selected from the group consisting of iron, copper, nickel, gold, silver, platinum, cobalt, zinc, lead, tin, titanium, chromium, aluminum, magnesium, manganese, or alloys thereof. Examples of the alloy include stainless steel, brass, and phosphor bronze. Among them, from the viewpoint of thermal conductivity, the material of the upper metal member 11A is preferably at least one selected from aluminum, an aluminum alloy, copper, or a copper alloy, and more preferably copper or a copper alloy. From the viewpoint of weight reduction and securing strength, the material of the upper metal member 11A is more preferably aluminum and an aluminum alloy.

### (1.1.2) Lower Metal Member

The lower metal member 12 is a container-shaped object opened upward. The shape of the lower metal member 12 viewed from above to below is a substantially rectangular shape having a long side in the front-rear direction. As illustrated in Fig. 3, the lower metal member 12 has a lower main surface BS12. The lower main surface BS12 constitutes a lower main surface BS1 of the heat exchange device 1A. The lower main surface BS12 has a planar shape.

As illustrated in Fig. 3, the lower metal member 12 has a partition wall portion 120 on the upper main surface TS12. The partition wall portion 120 partitions the internal flow path R1 in the heat exchange device 1A. The partition wall portion 120 has a surrounding wall portion 121 and a partition wall portion 122. Each of the surrounding wall portion 121 and the partition wall portion 122 protrudes upward from the upper main surface TS12 of the lower metal member 12.

As illustrated in Fig. 4, the surrounding wall portion 121 is formed along a peripheral edge P12 of the lower metal member 12 over an entire periphery of the peripheral edge P12.

The surrounding wall portion 121 has a front side wall portion 121A and a rear side wall portion 121B. The partition wall portion 122 extends from a center of the rear side wall portion 121B in the left-right direction toward the front side wall portion 121A. A front end portion 122A of the partition wall portion 122 and the front side wall portion 121A of the surrounding wall portion 121 are separated from each other.

As illustrated in Fig. 3, the upper main surface TS121 of the surrounding wall portion 121 is in contact with the lower main surface BS11 of the upper metal member 11A in the heat exchange device 1A. The upper main surface TS122 of the partition wall portion 122 and the lower main surface BS11 of the upper metal member 11A are separated from each other in the heat exchange device 1A.

The lower main surface BS11 of the upper metal member 11A, an inner surface IS121 of the surrounding wall portion 121, and the upper main surface TS12 of the lower metal member 12 constitute the internal flow path R1 in the heat exchange device 1A.

The material of the lower metal member 12 is a metal, and may be the same as that exemplified as the material of the upper metal member 11A. The material of the lower metal member 12 may be the same as or different from the material of the upper metal member 11A.

### (1.1.3) Resin Joint Portion

The resin joint portion 13 joins the upper metal member 11A and the lower metal member 12. As shown in Fig. 3, the overlapped body 100 has side surface recesses R100. The side surface recess R100 is formed over the entire periphery of the side surface SS100. The resin joint portion 13 is filled in the side surface recess R100. Accordingly, the upper metal member 11A and the lower metal member 12 are firmly joined even when they are not welded or brazed.

The side surface recess R100 includes an edge side lower main surface BS11A, an outer surface OS121, and an edge side upper main surface TS12A.

As illustrated in Fig. 3, the resin joint portion 13 is in contact with the edge side lower main surface BS11A, the outer surface OS121, the edge side upper main surface TS12A, a side surface SS11, and a side surface SS12.

Hereinafter, the edge side lower main surface BS11A of the upper metal member 11A, the outer surface OS121 of the surrounding wall portion 121, the edge side upper main surface TS12A of the lower metal member 12, the side surface SS11 of the upper metal member 11A, and the side surface SS12 of the lower metal member 12 are referred to as "joining fixing surface". The joining fixing surface is an example of a surface in contact with the resin joint portion of each of the pair of metal members.

The joining fixing surface is subjected to a roughening treatment. That is, the joining fixing surface has a fine uneven structure. Details of the roughening treatment will be described in a second roughening step to be described later.

The uneven structure formed by performing the roughening treatment on the joining fixing surface is not particularly limited as long as a joining strength between the upper metal member 11A and the lower metal member 12 is sufficiently obtained. An average hole diameter of the recesses in the uneven structure may be, for example, 5 nm to 250 µm, preferably 10 nm to 150 µm, and more preferably 15 nm to 100 µm. An average hole depth of the recesses in the uneven structure may be, for example, 5 nm to 250 µm, preferably 10 nm to 150 µm, and more preferably 15 nm to 100 µm. When either or both of the average hole diameter and the average hole depth of the recesses in the uneven structure are within the above numerical range, stronger joining tends to be obtained.

The average hole diameter and the average hole depth of the recesses in the uneven structure can be obtained by using an electron microscope or a laser microscope. Specifically, a surface and a cross section of the joining fixing surface are photographed. From the obtained photograph, 50 arbitrary recesses are selected, and the average hole diameter and the average hole depth of the recesses can be calculated as arithmetic average values from the hole diameter and the hole depth of the recesses, respectively.

The resin joint portion 13 is formed by injection molding. The material of the resin joint portion 13 is the same as the material of the resin sealing portion 30A. The material of the resin sealing portion 30A will be described later.

### (1.2) Joint Member

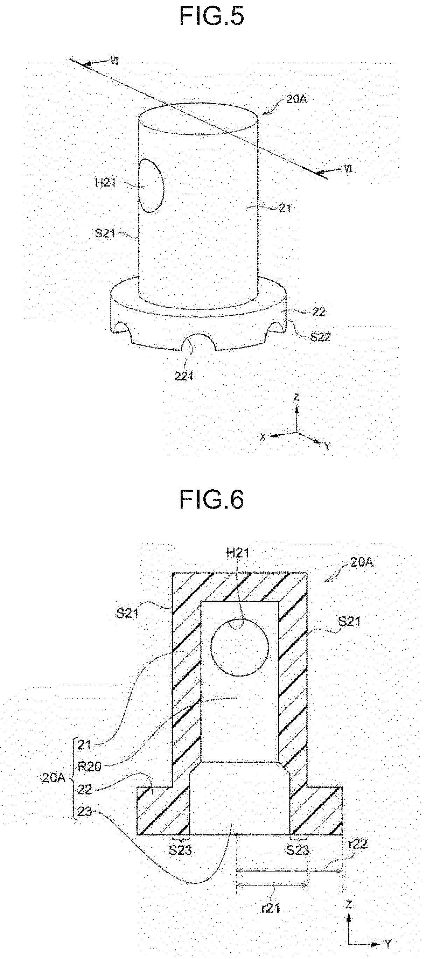

The joint member 20A is a molded body for supplying or discharging a cooling medium. As illustrated in Figs. 5 and 6, the joint member 20A has a protruding portion 21, a projecting portion 22, a hollow portion R20, and a main body portion 23 (see Fig. 6). The protruding portion 21, the projecting portion 22, and the main body portion 23 are integrated.

As illustrated in Fig. 6, the main body portion 23 is located at a lower portion of the joint member 20A in the vertical direction and at a central portion in a plane direction. The plane direction indicates a direction orthogonal to the vertical direction.

The main body portion 23 has a contact surface S23. The contact surface S23 and a lower surface of the projecting portion 22 come into contact with the upper main surface TS12 of the lower metal member 12 in the heat exchange device 1A. The main body portion 23 firmly supports the protruding portion 21 by the contact surface S23 coming into contact with the upper main surface TS12.

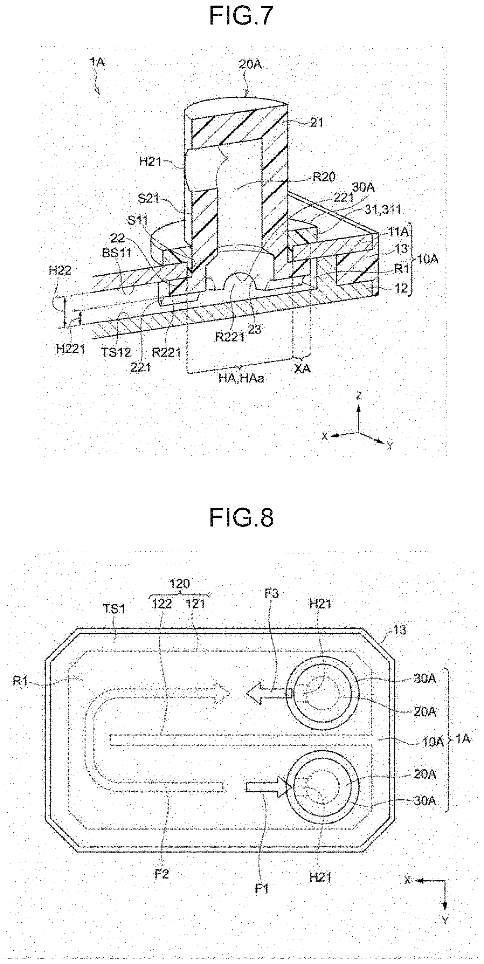

As illustrated in Fig. 7, the protruding portion 21 protrudes upward from the main body portion 23 toward the outside of the heat exchange main body portion 10A via the through-hole HA. As illustrated in Fig. 5, the protruding portion 21 has a columnar shape. The protruding portion 21 of the joint member 20A has an opening H21. A cooling medium is supplied or discharged from the opening H21 of the joint member 20A.

As illustrated in Fig. 7, the hollow portion R20 is formed to connect the opening H21 and the internal flow path R1 of the heat exchange main body portion 10A. The hollow portion R20 is formed inside the protruding portion 21.

As illustrated in Fig. 6, the projecting portion 22 projects from the main body portion 23 with respect to the outer peripheral surface S21 of the protruding portion 21. The projecting portion 22 is formed over an entire periphery of the outer peripheral surface S21 of the protruding portion 21. The shape of the projecting portion 22 viewed from above to below is a ring shape. As illustrated in Fig. 7, the projecting portion 22 is in contact with the lower main surface BS11 of the upper metal member 11A and the upper main surface TS12 of the lower metal member 12.

A radius r22 (see Fig. 6) of the projecting portion 22 can be appropriately adjusted according to the application of the heat exchange device 1A. For example, from the viewpoint of airtightness of the heat exchange device 1A, the radius r22 of the projecting portion 22 is preferably larger than a radius r21 (see Fig. 6) of the protruding portion 21 by a first distance. The first distance is preferably 0.5 mm to 20.0 mm, and more preferably 2.0 mm to 10.0 mm.

As illustrated in Fig. 7, the projecting portion 22 and the main body portion 23 have a notch portion 221. The notch portion 221 forms a flow path R221 with the upper main surface TS12 of the lower metal member 12 therebetween. The flow path R221 causes the hollow portion R20 of the joint member 20A and the internal flow path R1 of the heat exchange main body portion 10A to communicate with each other.

In the vertical direction, a depth H221 of the notch portion 221 is, for example, half a height H22 of the projecting portion 22 as illustrated in Fig. 7.

The projecting portion 22 has six notch portions 221. Each of the six notch portions 221 is formed at equal intervals over an entire periphery of the outer peripheral surface S22 of the projecting portion 22. The cross-sectional shape of the notch portion 221 is an arch shape.

The material of the joint member 20A is a resin, and the outer peripheral surface S21 of the protruding portion 21 of the joint member 20A and the resin sealing portion 30A are fused. Therefore, the joint member 20A can cope with complication of a shape, weight reduction of a device, cost reduction, and the like as compared with a case where the joint member is made of a metal.

The resin constituting the joint member 20A is not particularly limited, and may be a thermoplastic resin, a thermosetting resin, or the like. The thermoplastic resin includes an elastomer. Examples of the thermoplastic resin include a polyolefin-based resin, polyvinyl chloride, polyvinylidene chloride, a polystyrene-based resin, an acrylonitrile-styrene (AS) resin, an acrylonitrile-butadiene-styrene (AB) resin, a polyester-based resin, a poly (meth) acryl-based resin, polyvinyl alcohol, a polycarbonate-based resin, a polyamide-based resin, a polyimide-based resin, a polyether-based resin, a polyacetal-based resin, a fluorine-based resin, a polysulfone-based resin, a polyphenylene sulfide resin, and a polyketone-based resin. Examples of the thermosetting resin include a phenol resin, a melamine resin, a urea resin, a polyurethane-based resin, an epoxy resin, and an unsaturated polyester resin. These resins may be used alone, or may be used in combination of two or more thereof.

The resin constituting the joint member 20A may include various compounding agents. Examples of the compounding agent include a filler, a heat stabilizer, an antioxidant, a pigment, a weathering agent, a flame retardant, a plasticizer, a dispersant, a lubricant, a release agent, and an antistatic agent.

The resins constituting the pair of joint members 20A may be the same as or different from each other.

### (1.3) Resin Sealing Portion

As illustrated in Fig. 7, the resin sealing portion 30A seals a gap between the inner peripheral surface S11 of the through-hole HA of the upper metal member 11A and the outer peripheral surface S21 of the joint member 20A. In other words, the gap between the inner peripheral surface S11 of the through-hole HA and the outer peripheral surface S21 of the joint member 20A is filled with the resin sealing portion 30A.

The resin sealing portion 30A has a covering portion 31. The covering portion 31 covers the periphery of the through-hole HA of the upper main surface TS11 of the upper metal member 11A. The covering portion 31 has a first covering portion 311. The first covering portion 311 covers a first region XA of the upper main surface TS 11 of the upper metal member 11A. The first region XA indicates a region of the upper main surface TS11 of the upper metal member 11A facing the projecting portion 22 of the joint member 20A. The first covering portion 311 is formed over an entire periphery of the through-hole HA. A shape of the covering portion 31 viewed from above to below is a ring shape.

A thickness of the first covering portion 311 in the vertical direction is preferably 0.5 mm to 6.0 mm, and more preferably 1.0 mm to 4.0 mm from the viewpoint of airtightness of the heat exchange device 1A.

Hereinafter, the inner peripheral surface S11 of the through-hole HA of the upper metal member 11A and the first region XA of the upper main surface TS11 of the upper metal member 11A will be referred to as a "sealing fixing surface". The sealing fixing surface is an example of a surface of the metal wall portion with which the resin sealing portion is brought into contact.

The sealing fixing surface is subjected to a roughening treatment and has a fine uneven structure. Details of the roughening treatment will be described in a first roughening step described later.

The uneven structure of the sealing fixing surface is not particularly limited as long as the joining strength between the resin sealing portion 30A and the upper metal member 11A is sufficiently obtained, but may be the same as the uneven structure of the joining fixing surface.

The resin sealing portion 30A is formed by injection molding. A material of the resin sealing portion 30A is a resin having compatibility with the resin constituting the joint member 20A. Accordingly, the resin sealing portion 30A and the outer peripheral surface S21 of the protruding portion 21 of the joint member 20A are fused. In the disclosure, "having compatibility" indicates that the resin constituting the resin sealing portion 30A is mixed without being separated in an atmosphere where the resin is melted. The resin constituting the resin sealing portion 30A preferably has the same main component as the resin constituting the joint member 20A.

The resins constituting the pair of resin sealing portions 30A may be the same as or different from each other.

### (1.4) Flow of Cooling Medium

The heat exchange device 1A is installed and used such that, for example, the lower main surface BS1 of the heat exchange device 1A is in contact with the heating element. At this time, an external supply unit is coupled to one joint member 20A. The external supply unit supplies a cooling medium to the heat exchange device 1A. An external discharge unit is coupled to the other joint member 20A. The cooling medium is discharged from the heat exchange device 1A to the external discharge unit. The heat of the heating element is conducted to the cooling medium filled in the internal flow path R1 via the heat exchange main body portion 10A.

As illustrated in Fig. 8, the cooling medium is supplied from the external supply unit to the opening H21 of the one joint member 20A along a flow direction F1. The cooling medium moves to the internal flow path R1 via the hollow portion R20 and the flow path R221 of the one joint member 20A. Most of the cooling medium that has reached the internal flow path R1 moves in the internal flow path R1 toward the other joint member 20A along a flow direction F2. At this time, the cooling medium is warmed by heat exchange with the heat exchange main body portion 10A. On the other hand, the heat exchange main body portion 10A is cooled by heat exchange with the cooling medium. Next, the cooling medium moves to the opening H21 via the flow path R221 and the hollow portion R20 of the other joint member 20A, and is discharged from the opening H21 to the external discharge unit along a flow direction F3. In this manner, the cooling medium absorbs heat from the heating element inside the heat exchange device 1A and is discharged to the outside of the heat exchange device 1A. That is, the heat exchange device 1A promotes heat dissipation of the heating element.

### (1.5) Method for Manufacturing Heat Exchange Device

The method for manufacturing the heat exchange device 1A includes a preparation step, a first roughening step, a second roughening step, an insert step, and a sealing step. The preparation step, the insert step, and the sealing step are executed in this order. Each of the first roughening step and the second roughening step is not particularly limited as long as it is executed before the sealing step. The first roughening step may be executed simultaneously with the second roughening step, may be executed after the second roughening step is executed, or may be executed before the second roughening step is executed.

### (1.5.1) Preparation Step

In the preparation step, the joint member 20A is prepared. That is, the joint member 20A is molded in advance before the sealing step is executed. Therefore, the joint member 20A can be molded into a more complicated shape as compared with a case of being injection molded in the sealing step. The complicated shape includes, for example, an undercut. The undercut includes a packing groove or a connecting groove. Therefore, for example, a complicated connector such as a rotary connector can be connected to the protruding portion 21 of the joint member 20A in order to be connected to an external supply unit or an external discharge unit. As a result, the heat exchange device 1A that can be used in various fields is obtained.

The method for preparing the joint member 20A is not particularly limited, and can be appropriately adjusted according to the application of the heat exchange device 1A. Examples of a method for preparing the joint member 20A include resin molding. Examples of the resin molding include injection molding, cast molding, press molding, insert molding, extrusion molding, and transfer molding.

### (1.5.2) First Roughening Step

In the first roughening step, the sealing fixing surface of the upper metal member 11A is subjected to a roughening treatment. Accordingly, a fine uneven structure is formed on each of the sealing fixing surfaces before executing the sealing step. Therefore, in the sealing step, a resin melt (hereinafter, referred to as a "resin melt") constituting the resin sealing portion 30A easily enters the gap of the fine uneven structure of the sealing fixing surface by an injection pressure. In other words, by the anchor effect, it is possible to obtain a resin sealing portion that is firmly fixed to the upper metal member 11A as compared with a case where the roughening treatment is not performed. As a result, the heat exchange device 1A capable of maintaining airtightness for a long period of time is obtained.

The method for performing the roughening treatment is not particularly limited. The method for performing the roughening treatment is, for example, a method using a laser as disclosed in Japanese Patent No. 4020957; an immersion method using aqueous solution of inorganic base such as NaOH or inorganic acid such as HCl or HNO₃; a method using anodization as disclosed in Japanese Patent No. 4541153; a substituted crystallization as disclosed in WO 2015-8847; an immersion method as disclosed in WO 2009/31632; a hot water treatment method as disclosed in Japanese Patent Application Laid-Open (JP-A) No. 2008-162115; blasting, or the like. The method for performing the roughening treatment can be selectively used according to the material of the sealing fixing surface of the upper metal member 11A, the state of the desired uneven structure, and the like.

The roughening treatment may be performed, for example, on a portion different from the sealing fixing surface of the upper metal member 11A. For example, of the upper main surface TS11 of the upper metal member 11A, the roughening treatment may be performed around the sealing fixing surface.

In the first roughening step, the sealing fixing surface may be subjected to a treatment of adding a functional group (hereinafter, described as "surface modification treatment") in addition to the roughening treatment. By subjecting the sealing fixing surface to the surface modification treatment, a chemical bonding between the sealing fixing surface and the resin sealing portion 30A increases. As a result, the joining strength of the resin sealing portion 30A to the upper metal member 11A tends to be further improved.

The surface modification treatment is preferably performed simultaneously with or after the roughening treatment. The method for performing the surface modification treatment is not particularly limited, and can be appropriately adopted by a known method.

### (1.5.3) Second Roughening Step

In the second roughening step, the joining fixing surface of the overlapped body 100 is subjected to a roughening treatment. Accordingly, a fine uneven structure is formed on the joining fixing surface of the overlapped body 100 before executing the sealing step. Therefore, in the sealing step, the resin melt easily enters the gap of the fine uneven structure of the joining fixing surface by an injection pressure. In other words, by the anchor effect, the resin joint portion 13 is obtained in which the upper metal member 11A and the lower metal member 12 are joined more firmly than in a case where the roughening treatment is not performed. As a result, the heat exchange device 1A capable of maintaining airtightness for a long period of time is obtained.

Examples of the method for performing the roughening treatment include the same methods as those exemplified as the method for performing the roughening treatment in the first roughening step. The method for performing the roughening treatment in the second roughening step may be the same as or different from the method for performing the roughening treatment in the first roughening step. When the second roughening step is executed simultaneously with the first roughening step, the method for performing the roughening treatment in the second roughening step is the same as the method for performing the roughening treatment in the first roughening step.

In the second roughening step, in addition to the roughening treatment, the surface modification treatment may be performed to the joining fixing surface of the overlapped body 100 in the same manner as in the first roughening step.

### (1.5.4) Insert Step

In the insert step, the pair of joint members 20A is disposed inside the heat exchange main body portion 10A, and the protruding portions 21 of the pair of joint members 20A protrude toward the outside of the heat exchange main body portion 10A via the through-holes HA.

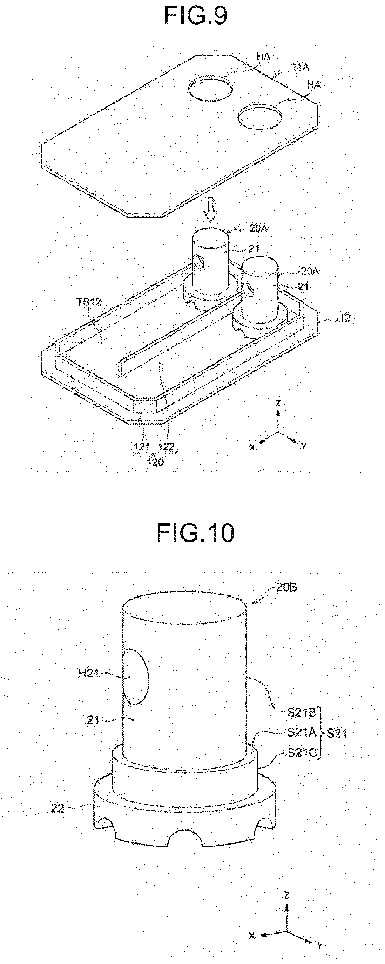

Specifically, in the insert step, as illustrated in Fig. 9, the pair of joint members 20A is disposed on the lower metal member 12. Next, the upper metal member 11A is overlapped on the lower metal member 12. Accordingly, an insert is obtained. As described above, in the first embodiment, even when the size of the projecting portion 22 of the joint member 20A is larger than the size of the through-hole HA, the joint member 20A can be disposed inside the heat exchange main body portion 10A.

### (1.5.5) Sealing Step

In the sealing step, the resin sealing portion 30A is formed in a gap between the inner peripheral surface S11 of the through-hole HA and the outer peripheral surface S21 of the protruding portion 21, thereby sealing the gap and forming the resin joint portion 13. Accordingly, the resin sealing portion 30A and the resin joint portion 13 are formed more efficiently than a case where the resin sealing portion 30A and the resin joint portion 13 are formed in separate steps. Even when the joint member 20A is not joined to the heat exchange main body portion 10A by brazing or welding, the heat exchange device 1A having excellent airtightness can be obtained.

Specifically, in the sealing step, the resin sealing portion 30A is formed in a gap between the inner peripheral surface S11 of the through-hole HA and the outer peripheral surface S21 of the protruding portion 21 of the joint member 20A by injection molding, and the resin joint portion 13 is formed in the side surface recess R100.

An injection molding machine is used for the injection molding. The injection molding machine includes an injection molding mold, an injection device, and a mold clamping device. The injection molding mold includes a movable-side mold and a fixed-side mold. The fixed-side mold is fixed to the injection molding machine. The movable-side mold is movable with respect to the fixed-side mold. The injection device injects the resin melt into a sprue of the injection molding mold at a predetermined injection pressure. The mold clamping device clamps the movable-side mold at a high pressure so that the movable-side mold is not opened by a filling pressure of the resin melt.

First, the movable-side mold is opened, the insert is placed on the fixed-side mold, the movable-side mold is closed, and the mold is clamped. That is, the insert is accommodated in the injection molding mold. Accordingly, a first space for forming the resin sealing portion 30A, a second space for forming the resin joint portion 13, and a third space for accommodating the protruding portion 21 in the injection molding mold are formed between the insert and the injection molding mold.

Next, the injection molding machine fills the first space and the second space with the resin melt at a high pressure.

At this time, the projecting portion 22 of the joint member 20A is in contact with the lower main surface BS11 of the upper metal member 11A and the upper main surface TS12 of the lower metal member 12. That is, the projecting portion 22 functions as a support of the upper metal member 11A. Accordingly, even when the injection pressure is applied downward to the upper metal member 11A, the upper metal member 11A is hardly deformed. Further, a path through which the resin melt intrudes into the internal flow path R1 of the heat exchange main body portion 10A is blocked by the projecting portion 22. Therefore, the projecting portion 22 suppresses intrusion of the resin melt into the internal flow path R1.

Next, the resin melt in the injection molding mold is cooled and solidified. Accordingly, the resin sealing portion 30A and the resin joint portion 13 are formed in the insert. That is, the heat exchange device 1A is obtained.

### (1.6) Action and Effect

As described with reference to Figs. 1 to 9, in the first embodiment, the heat exchange device 1A includes a heat exchange main body portion 10A, a pair of joint members 20A, and a pair of resin sealing portions 30A. The resin sealing portion 30A seals a gap between the inner peripheral surface S11 of the through-hole HA and the outer peripheral surface S21 of the protruding portion 21.

Accordingly, the heat exchange device 1A can prevent leakage of the cooling medium or intrusion of foreign matter from the outside of the heat exchange device 1A from the gap between the through-hole HA and the protruding portion 21 of the joint member 20A. That is, the heat exchange device 1A has excellent airtightness even when the joint member 20A is not joined to the heat exchange main body portion 10A by brazing or welding.

As described with reference to Figs. 1 to 9, in the first embodiment, the heat exchange main body portion 10A has the lower metal member 12. The joint member 20A has the projecting portion 22. The projecting portion 22 is in contact with the lower main surface BS11 of the upper metal member 11A and the upper main surface TS12 of the lower metal member 12.

Accordingly, the projecting portion 22 functions as a support of the upper metal member 11A. Therefore, even when a pressing force is applied downward to the upper metal member 11A, the upper metal member 11A is hardly deformed. For example, when the resin sealing portion 30A is formed by injection molding, the projecting portion 22 serves as a support of the upper metal member 11A against injection pressure. Therefore, the upper metal member 11A is hardly deformed. As a result, the heat exchange device 1A can reduce the pressure loss of the heat exchange medium flowing through the internal flow path R1. That is, the heat exchange device 1A can efficiently cause the cooling heat medium to flow through the internal flow path R1.

As described with reference to Figs. 1 to 9, in the first embodiment, the pair of sealing fixing surfaces is subjected to a roughening treatment.

Accordingly, the covering portion 31 is firmly fixed to the upper metal member 11A by the anchor effect as compared with a case where the roughening treatment is not performed. As a result, the heat exchange device 1A can maintain airtightness for a longer period of time.

As described with reference to Figs. 1 to 9, in the first embodiment, the resin sealing portion 30A has the covering portion 31.

Accordingly, the contact area between the resin sealing portion 30A and the upper metal member 11A is larger than that in a case where the resin sealing portion 30A does not have the covering portion 31. Therefore, the resin sealing portion 30A is firmly fixed to the upper metal member 11A as compared with a case where the resin sealing portion 30A does not have the covering portion 31. As a result, the heat exchange device 1A can maintain airtightness for a long period of time.

As described with reference to Figs. 1 to 9, in the first embodiment, the covering portion 31 has the first covering portion 311 that covers the first region XA.

Accordingly, for example, even when the resin sealing portion 30A is injection-molded and the thickness of the upper metal member 11A is relatively thin, the occurrence of deformation of the upper metal member 11A due to the injection pressure is suppressed. Further, the contact area between the resin sealing portion 30A and the upper metal member 11A is larger than that in a case where the resin sealing portion 30A does not have the first covering portion 31. Therefore, the resin sealing portion 30A is more firmly fixed to the metal wall portion. As a result, the heat exchange device 1A can maintain airtightness for a longer period of time.

As described with reference to Figs. 1 to 9, in the first embodiment, the projecting portion 22 has the notch portion 221.

Accordingly, the joint member 20A does not have the notch portion 221, and can form a passage of a cooling medium having a larger volume than a case where the hollow portion R20 and the internal flow path R1 directly communicate with each other. Therefore, the pressure loss of the cooling medium flowing through the internal flow path R1 is reduced. As a result, the heat exchange device 1A can efficiently cause the cooling medium to flow through the internal flow path R1.

As described with reference to Figs. 1 to 9, in the first embodiment, the cross-sectional shape of the notch portion 221 is an arch shape.

Accordingly, even when a pressing force is applied downward to the upper metal member 11A, the flow path R221 is less likely to be deformed as compared with a case of not having an arch shape. Therefore, the pressure loss of the cooling medium flowing through the internal flow path R1 is reduced. As a result, the heat exchange device 1A can cause the cooling medium to flow through the internal flow path R1 more efficiently.

As described with reference to Figs. 1 to 9, in the first embodiment, the outer peripheral surface S21 of the protruding portion 21 of the joint member 20A is made of a resin. The outer peripheral surface S21 of the protruding portion 21 and the resin sealing portion 30A are fused.

Accordingly, the resin sealing portion 30A and the joint member 20A are firmly fixed to each other. As a result, the heat exchange device 1A can maintain airtightness for a longer period of time.

As described with reference to Figs. 1 to 9, in the first embodiment, the resin sealing portion 30A and the resin joint portion 13 are formed by injection molding.

Accordingly, the resin sealing portion 30A enters the gap of the fine uneven portion of the sealing fixing surface. Therefore, the resin sealing portion 30A is firmly fixed to the upper metal member 11A. The resin joint portion 13 enters the gap of the fine uneven portion of the joining fixing surface. Therefore, the resin joint portion 13 firmly joins the upper metal member 11A and the lower metal member 12. As a result, the heat exchange device 1A can maintain airtightness for a longer period of time.

### (2) Second Embodiment

A heat exchange device 1B according to a second embodiment is different from the heat exchange device 1A according to the first embodiment mainly in that the outer peripheral surface of the protruding portion has a step surface.

The heat exchange device 1B includes a heat exchange main body portion 10A, a pair of joint members 20B, and a pair of resin sealing portions 30B.

As illustrated in Fig. 10, the outer peripheral surface S21 of the protruding portion 21 of the joint member 20B has a distal end side outer peripheral surface S21B, a proximal end side outer peripheral surface S21C, and a step surface S21A. The proximal end side outer peripheral surface S21C has a larger diameter than the distal end side outer peripheral surface S21B. The step surface S21A couples the distal end side outer peripheral surface S21B and the proximal end side outer peripheral surface S21C. The step surface S21A is orthogonal to the vertical direction. The shape of the step surface S21A viewed from above to below is a ring shape. The distal end side outer peripheral surface S21B, the proximal end side outer peripheral surface S21C, and the step surface S21A are formed over the entire periphery of the outer peripheral surface S21 of the protruding portion 21.

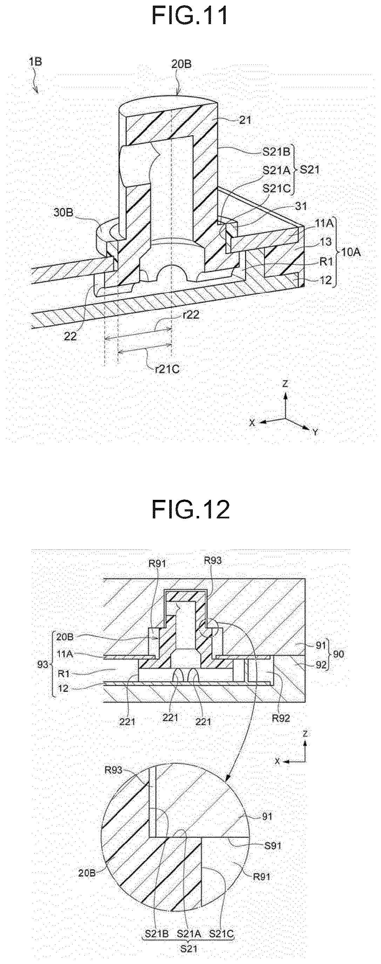

As illustrated in Fig. 11, the resin sealing portion 30B has a covering portion 31. The covering portion 31 covers only the proximal end side outer peripheral surface S21C of the outer peripheral surface S21 of the protruding portion 21. The covering portion 31 covers a part of the first region XA (see Fig. 7) of the upper main surface TS11 of the upper metal member 11A.

The radius r22 (see Fig. 11) of the projecting portion 22 of the joint member 20B can be appropriately adjusted according to the application of the heat exchange device 1B. For example, from the viewpoint of airtightness of the heat exchange device 1B, the radius r22 of the projecting portion 22 is preferably larger by a second distance with respect to a radius r21C (see Fig. 11) of a portion corresponding to the proximal end side outer peripheral surface S21C of the protruding portion 21. The second distance is preferably 0.5 mm to 20.0 mm, and more preferably 2.0 mm to 10.0 mm.

The method for manufacturing the heat exchange device 1B according to the second embodiment is executed in the same manner as the method for manufacturing the heat exchange device 1A according to the first embodiment.

The method for manufacturing the heat exchange device 1B includes a preparation step, a first roughening step, a second roughening step, an insert step, and a sealing step.

In the sealing step, when the molds of the movable-side mold 91 and the fixed-side mold 92 of the injection molding mold 90 are clamped, as illustrated in Fig. 12, a first space R91 forming the resin sealing portion 30B, a second space R92 forming the resin joint portion 13, and a third space R93 for accommodating the protruding portion 21 in the injection molding mold are formed between the insert 93 and the injection molding mold 90.

In the second embodiment, a part of a transfer side surface 91S of the movable-side mold 91 is in contact with the step surface S21A. That is, a path connecting the first space R91 and the third space R93 is blocked by the contact between the transfer side surface 91S and the step surface S21A. Therefore, even when the first space R91 is filled with the resin melt, the molten resin in the first space R91 does not move into the third space R93. As a result, the generation of burrs caused by the intrusion of the resin melt into the third space R93 is suppressed. That is, the heat exchange device 1B is obtained in which an unnecessary resin shape such as burrs is not formed.

As described with reference to Figs. 1 to 4 and 8 to 12, in the second embodiment, the outer peripheral surface S21 of the protruding portion 21 of the joint member 20B has the distal end side outer peripheral surface S21B, the proximal end side outer peripheral surface S21C, and the step surface S21A. The covering portion 31 covers only the proximal end side outer peripheral surface S21C of the outer peripheral surface S21 of the protruding portion 21.

Accordingly, when the resin sealing portion 30B is formed by insert molding, which is one type of injection molding, the step surface S21A can suppress the formation of the burrs. As a result, the heat exchange device 1B is excellent in an appearance.

The heat exchange device 1B according to the second embodiment has the same action and effect as those of the heat exchange device 1A according to the first embodiment.

### (3) Third Embodiment

A heat exchange device 1C according to a third embodiment is different from the heat exchange device 1A according to the first embodiment in a shape of a joint member.

The heat exchange device 1C includes a heat exchange main body portion 10A, a pair of joint members 20C, and a pair of resin sealing portions 30B.

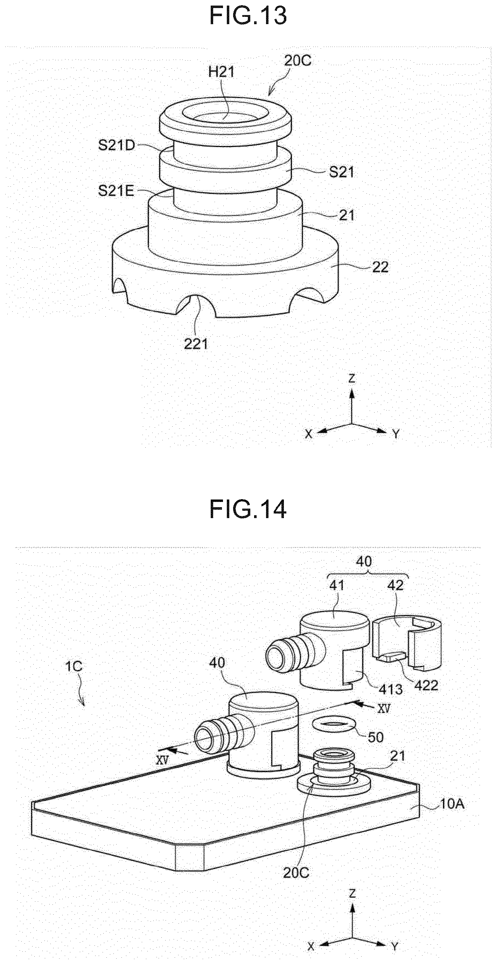

The joint member 20C has a protruding portion 21, a hollow portion R20, a projecting portion 22, and a main body portion 23. As illustrated in Fig. 13, the opening H21 of the protruding portion 21 faces upward.

The outer peripheral surface S21 of the protruding portion 21 has an upper annular groove S21D and a lower annular groove S21E. The upper annular groove S21D is located above the lower annular groove S21E. Each of the upper annular groove S21D and the lower annular groove S21E is formed over the entire periphery of the outer peripheral surface S21.

### (3.1) Usage Form

As illustrated in Fig. 14, the heat exchange device 1C is used with a pair of joint members 20C and a pair of connector components 40 attached thereto.

### (3.1.1) Connector Component

The connector component 40 is attached to the protruding portion 21 of the joint member 20C.

As illustrated in Fig. 14, the connector component 40 includes a main body portion 41 and a lid portion 42. The lid portion 42 is attached to the main body portion 41.

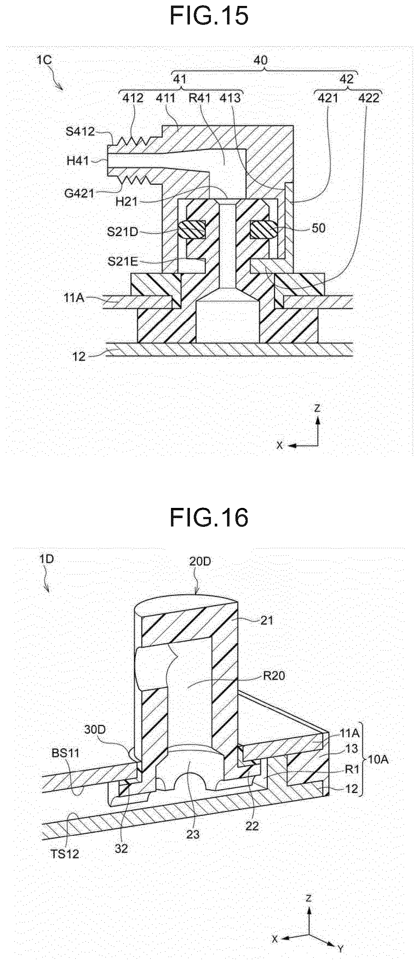

As illustrated in Fig. 15, the main body portion 41 has a housing portion 411, a connecting protruding portion 412, a fitting recess 413, and a hollow portion R41.

The housing portion 411 is a substantially cylindrical object.

The connecting protruding portion 412 is formed for connecting an external supply unit or a discharge unit. The connecting protruding portion 412 is located at an upper portion of the housing portion 411. The connecting protruding portion 412 protrudes in a direction orthogonal to the vertical direction with respect to the outer peripheral surface S411 of the housing portion 411. The connecting protruding portion 412 has an opening H41. The cooling medium is supplied from the external supply unit or discharged to the external discharge unit through the opening H41 of the connector component 40. A connecting groove G412 for fixing the external supply unit is formed on the outer peripheral surface S412 of the connecting protruding portion 412 of the connector component 40.

The lid portion 42 is fitted into the fitting recess 413. The fitting recess 413 is formed so as to be located on the side opposite to the connecting protruding portion 412 in the outer peripheral surface S411 of the housing portion 411.

The hollow portion R41 causes the opening H41 and the opening H21 of the protruding portion 21 of the joint member 20C to communicate with each other. The hollow portion R41 is formed inside the connecting protruding portion 412 and the housing portion 411.

The lid portion 42 has a fitting portion 421 and an engagement protrusion portion 422. The fitting portion 421 is fitted into the fitting recess 413 of the main body portion 41. The engagement protrusion portion 422 of the connector component 40 is engaged with the lower annular groove S21E of the joint member 20C when the fitting portion 421 is fitted into the fitting recess 413 of the main body portion 41. Accordingly, the connector component 40 is rotatable with respect to the joint member 20C along the lower annular groove S21E.

The material of the connector component 40 is not particularly limited, and is, for example, a metal or a resin.

As illustrated in Fig. 15, an O-ring 50 is fitted into the upper annular groove S21D of the protruding portion 21. The O-ring 50 prevents leakage of a cooling medium or intrusion of foreign matter from the outside through a gap between the connector component 40 and the protruding portion 21 of the joint member 20C.

The heat exchange device 1C according to the third embodiment has the same action and effect as those of the heat exchange device 1A according to the first embodiment.

### (4) Fourth Embodiment

A heat exchange device 1D according to a fourth embodiment is different from the heat exchange device 1A according to the first embodiment mainly in that the projecting portion is not in direct contact with the lower main surface of the upper metal member.

The heat exchange device 1D includes a heat exchange main body portion 10A, a pair of joint members 20D, and a pair of resin sealing portions 30D.

The joint member 20D has a protruding portion 21, a hollow portion R20, a projecting portion 22, and a main body portion 23. As illustrated in Fig. 16, the projecting portion 22 of the j oint member 20D is in physical contact only with the upper main surface TS12 of the lower metal member 12. That is, the projecting portion 22 is not in physical contact with the lower main surface BS11 of the upper metal member 11A.

The resin sealing portion 30D has a filling portion 32. The filling portion 32 fills a gap between the projecting portion 22 and the lower main surface BS11 of the upper metal member 11A. The resin sealing portion 30D does not have the covering portion 31.

The heat exchange device 1D according to the fourth embodiment has the same action and effect as those of the heat exchange device 1A according to the first embodiment.

### (5) Fifth Embodiment

A heat exchange device 1E according to a fifth embodiment is different from the heat exchange device 1A according to the first embodiment mainly in that the covering portion of the resin sealing portion further covers the outside of the first region of the upper main surface of the upper metal member.

The heat exchange device 1E includes a heat exchange main body portion 10A, a pair of joint members 20B, and a pair of resin sealing portions 30E.

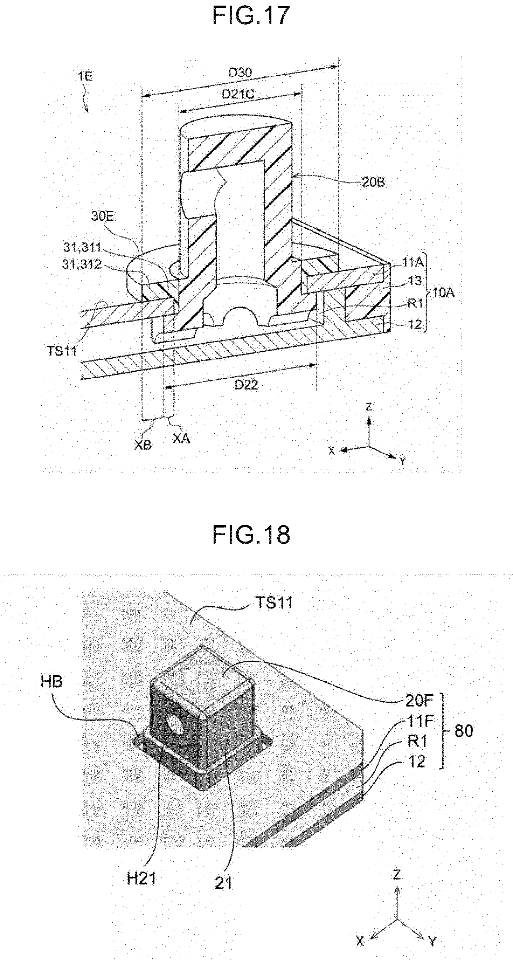

As illustrated in Fig. 17, the covering portion 31 of the resin sealing portion 30E has a first covering portion 311 and a second covering portion 312. The second covering portion 312 covers a second region XB of the upper main surface TS11 of the upper metal member 11A. The second region XB indicates a region outside the first region XA of the upper main surface TS11 of the upper metal member 11A with respect to the through-hole HA. The first covering portion 311 and the second covering portion 312 are integrated. The resin sealing portion 30E has a ring shape when viewed from above to below.

From the viewpoint of improving the joining strength of the resin sealing portion 30E to the upper metal member 11A, an upper limit of a diameter D30 (see Fig. 17) of the resin sealing portion 30E is preferably equal to or less than a value obtained by adding a numerical value three times the thickness of the upper metal member 11A in the vertical direction to a diameter D22 (see Fig. 17) of the projecting portion 22. The diameter D22 is twice the radius r22 (see Fig. 11) described in the second embodiment. When the upper limit of the diameter D30 of the resin sealing portion 30E is within the above range, the upper metal member 11A is less likely to be bent by the injection pressure when the resin sealing portion 30E is formed by insert molding, which is one type of injection molding. Therefore, the projecting portion 22 can further suppress intrusion of the resin melt into the internal flow path R1. On the other hand, a lower limit of the diameter D30 of the resin sealing portion 30E is preferably equal to or larger than a value obtained by adding 0.5 mm to a diameter D21C (see Fig. 17) of the portion corresponding to the proximal end side outer peripheral surface S21C of the protruding portion 21. The diameter D21C is twice the radius r21C (see Fig. 11) described in the second embodiment.

As described with reference to Fig. 17, in the fifth embodiment, the covering portion 31 of the resin sealing portion 30E has the second covering portion 312 that covers the second region XB.

Accordingly, the contact area between the resin sealing portion 30E and the pair of sealing fixing surfaces is wider than that in the first embodiment. Therefore, the resin sealing portion 30E is more firmly fixed to the upper metal member 11A than in the first embodiment. As a result, the heat exchange device 1E can maintain airtightness for a longer period of time than in the first embodiment.

The heat exchange device 1E according to the fifth embodiment has the same action and effect as those of the heat exchange device 1A according to the first embodiment.

### (6) Sixth Embodiment

A heat exchange device 1F according to a sixth embodiment is different from the heat exchange device 1A according to the first embodiment mainly in that each of a protruding portion, a through-hole, and a covering portion has a substantially square shape.

The heat exchange device 1F includes a heat exchange main body portion 10F, a pair of joint members 20F, and a pair of resin sealing portions 30F.

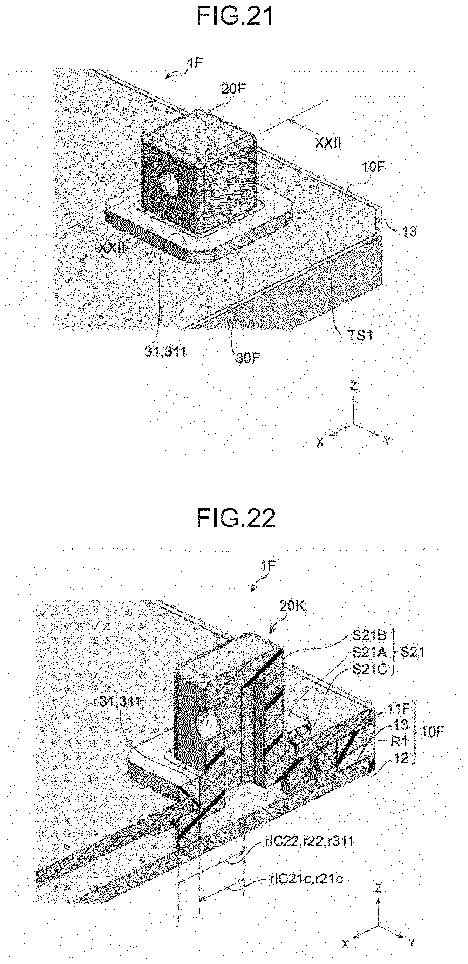

As illustrated in Fig. 18, the heat exchange main body portion 10F has an internal flow path R1, an upper metal member 11F, a lower metal member 12, and a resin joint portion 13 (see Fig. 21). The upper metal member 11F has a pair of through-holes HB. The shape of the through-hole HB viewed from above to below is a substantially square shape.

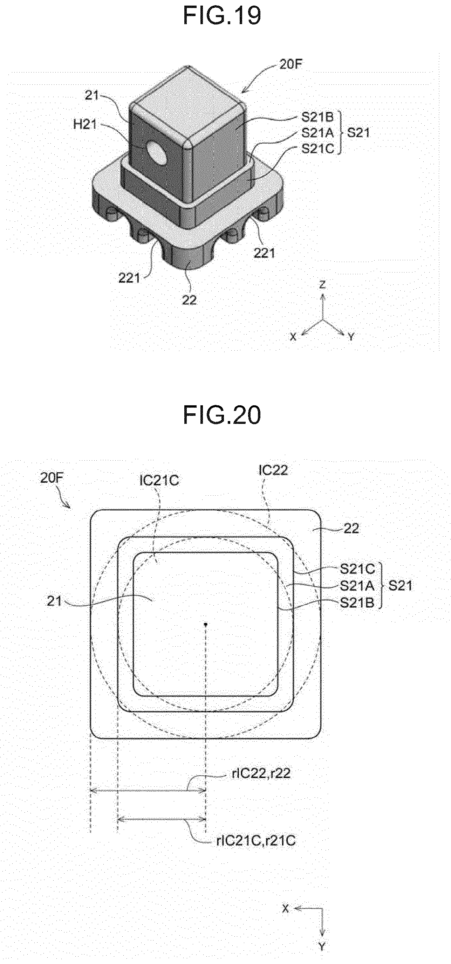

As illustrated in Fig. 19, the outer peripheral surface S21 of the protruding portion 21 of the joint member 20F has a distal end side outer peripheral surface S21B, a proximal end side outer peripheral surface S21C, and a step surface S21A. The shape of the distal end side outer peripheral surface S21B viewed from above to below is substantially square. The shape of each of the proximal end side outer peripheral surface S21C and the step surface S21A viewed from above to below is a substantially square ring shape.

In the sixth embodiment, the shape of the projecting portion 22 viewed from above to below is a substantially square ring shape. As illustrated in Fig. 20, in a plane orthogonal to the vertical direction, a radius rIC22 of an inscribed circle IC22 of the projecting portion 22 is the same as the radius r22 (see Fig. 11) described in the second embodiment. In the plane orthogonal to the vertical direction, a radius rIC21C of the inscribed circle IC21C of the proximal end side outer peripheral surface S21C of the protruding portion 21 is the same as the radius r21C (see Fig. 11) described in the second embodiment. For example, the radius rIC22 of the inscribed circle IC22 of the projecting portion 22 according to the sixth embodiment is preferably larger than the radius rIC21C by the second distance described in the second embodiment from the viewpoint of airtightness of the heat exchange device 1F.

As illustrated in Fig. 21, the resin sealing portion 30F has a covering portion 31. The covering portion 31 has a first covering portion 311. The first covering portion 311 is formed over an entire periphery of the through-hole HB. The shape of the covering portion 31 viewed from above to below is a substantially square ring shape.

In the sixth embodiment, as described above, the radius rIC22 of the inscribed circle IC22 of the projecting portion 22 is the same as the radius r22 described in the second embodiment. That is, in the plane orthogonal to the vertical direction, a radius r311 (see Fig. 22) of the inscribed circle of the first covering portion 311 is also the same as the radius r22 described in the second embodiment. Therefore, the contact area between the first covering portion 311 and the upper metal member 11F according to the sixth embodiment is larger than that of the second embodiment. As a result, the resin sealing portion 30 according to the sixth embodiment is more firmly fixed to the upper metal member 11F than in the second embodiment.

The heat exchange device 1F according to the sixth embodiment has the same action and effect as those of the heat exchange device 1A according to the first embodiment.

### (7) Seventh Embodiment

A heat exchange device 1G according to a seventh embodiment is different from the heat exchange device 1A according to the first embodiment mainly in that a resin sealing portion has a step portion.

The heat exchange device 1G according to the seventh embodiment includes a heat exchange main body portion 10A, a pair of joint members 20A, and a pair of resin sealing portions 30G.

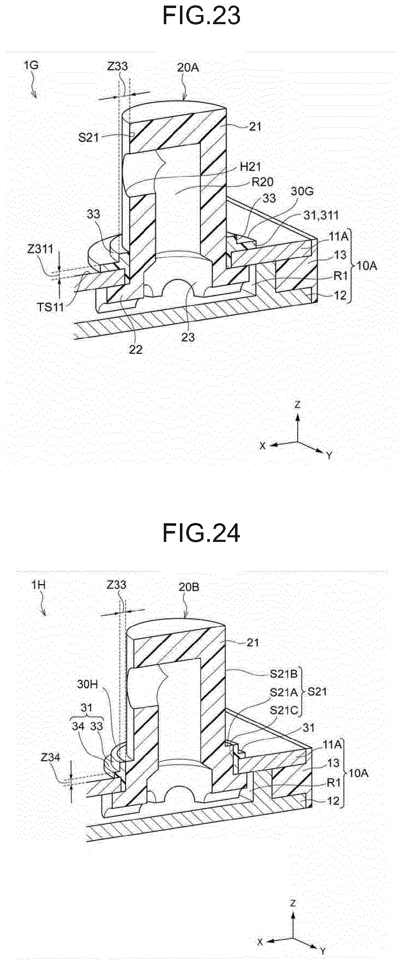

As illustrated in Fig. 23, the resin sealing portion 30G has a covering portion 31. The covering portion 31 of the resin sealing portion 30G has a first covering portion 311.

The resin sealing portion 30G further has a step portion 33. The step portion 33 is located on the protruding portion 21 side and on the upper side with respect to the covering portion 31. The step portion 33 is formed over the entire periphery of the outer peripheral surface S21 of the protruding portion 21. The covering portion 31 and the step portion 33 are integrated. That is, the step portion 33 protrudes upward from the covering portion 31 along the outer peripheral surface S21 of the protruding portion 21. The shape of the step portion 33 viewed from above to below is a ring shape.

In the seventh embodiment, a thickness Z311 (see Fig. 23) of the first covering portion 311 in the vertical direction is substantially the same as a thickness Z33 (see Fig. 23) of the step portion 33 in the direction orthogonal to the vertical direction. In other words, a thickness of a portion of the resin sealing portion 30G above the upper main surface TS11 of the upper metal member 11A is substantially uniform. Accordingly, a resin amount of the resin sealing portion 30G can be reduced as compared with the resin sealing portion 30A (see Fig. 7) of the first embodiment. When the resin sealing portion 30G is formed by injection molding, a time required for cooling and solidifying the resin melt can be further shortened and a shrinkage stress generated at the time of cooling and solidifying the resin melt can be further reduced as compared with the resin sealing portion 30A (see Fig. 7) of the first embodiment.

Each of the thickness Z311 (see Fig. 23) and the thickness Z33 (see Fig. 23) is preferably 0.5 mm to 6.0 mm, more preferably 1.0 mm to 4.0 mm, and particularly preferably 2.0 mm.

The heat exchange device 1G according to the seventh embodiment has the same action and effect as those of the heat exchange device 1A according to the first embodiment.

### (8) Eighth Embodiment

A heat exchange device 1H according to an eighth embodiment is different from the heat exchange device 1A according to the first embodiment mainly in that the covering portion 31 of the resin sealing portion 30 does not have the first covering portion 311.

The heat exchange device 1H includes a heat exchange main body portion 10A, a pair of joint members 20B, and a pair of resin sealing portions 30H.

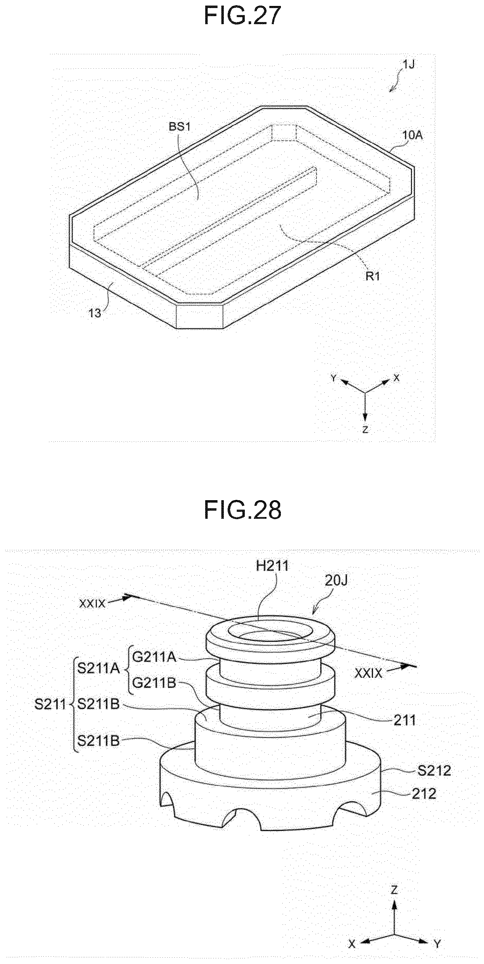

As illustrated in Fig. 27, the outer peripheral surface S21 of the protruding portion 21 of the joint member 20B has a distal end side outer peripheral surface S21B, a proximal end side outer peripheral surface S21C, and a step surface S21A.

The resin sealing portion 30H has a covering portion 31. The covering portion 31 of the resin sealing portion 30H covers only the proximal end side outer peripheral surface S21C of the outer peripheral surface S21 of the protruding portion 21. The covering portion 31 of the resin sealing portion 30H covers a part of the first region XA of the upper main surface TS11 of the upper metal member 11A.

Hereinafter, an outer edge portion 34 of the covering portion 31 of the resin sealing portion 30H on the side opposite to the protruding portion 21 side is referred to as an "outer edge covering portion 34".

The resin sealing portion 30H has a covering portion 31 and a step portion 33.

In the eighth embodiment, a thickness Z34 (see Fig. 24) of the outer edge covering portion 34 in the vertical direction is substantially the same as the thickness Z33 (see Fig. 24) of the step portion 33 in the direction orthogonal to the vertical direction. In other words, a thickness of a portion of the resin sealing portion 30 above the upper main surface TS11 of the upper metal member 11A is substantially uniform. Accordingly, a resin amount of the resin sealing portion 30H can be reduced as compared with the resin sealing portion 30A (see Fig. 7) of the first embodiment. When the resin sealing portion is formed by injection molding, the time required for cooling and solidifying the resin melt can be further shortened and a shrinkage stress generated at the time of cooling and solidifying the resin melt can be further reduced as compared with the resin sealing portion 30A (see Fig. 7) of the first embodiment.

Each of the thickness Z34 (see Fig. 24) and the thickness Z33 (see Fig. 24) is preferably 0.5 mm to 6.0 mm, more preferably 1.0 mm to 4.0 mm, and particularly preferably 2.0 mm.

The heat exchange device 1H according to the eighth embodiment has the same action and effect as those of the heat exchange device 1A according to the first embodiment.

### (9) Ninth Embodiment

In the ninth embodiment, a heat exchange device 1J is used to promote heat dissipation of an external heating element. Examples of the heating element include those the same as those exemplified as the heating element according to the first embodiment.

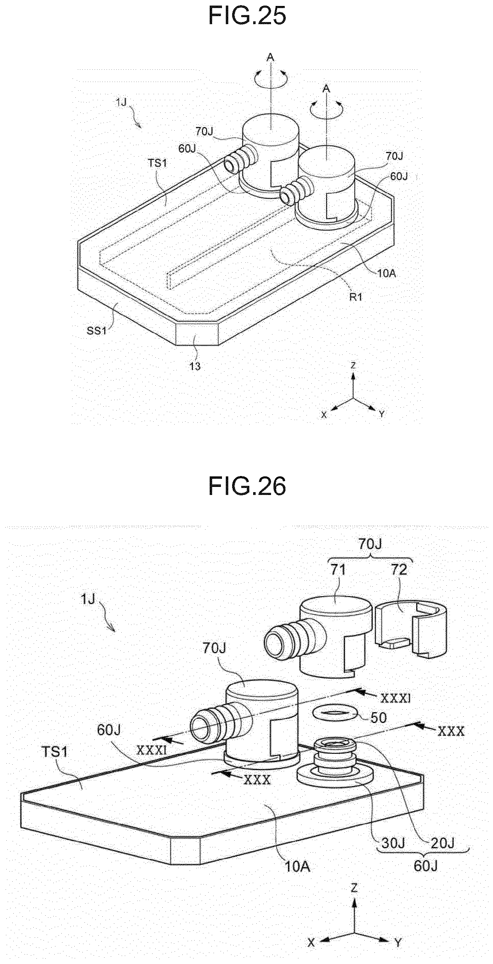

As illustrated in Figs. 25 and 26, the heat exchange device 1J includes a heat exchange main body portion 10A, a pair of first components 60J, a pair of second components 70J, and two O-rings 50 (see Fig. 26). One of the pair of first components 60J is for supply, and the other is for discharge. One of the pair of second components 70J is for supply, and the other is for discharge. The first component 60J is an example of a first component. The second component 70J is an example of a second component. The O-ring 50 is an example of a packing.

In the ninth embodiment, the side of the heat exchange device 1J on which the second component 70J is disposed is defined as a rear side of the heat exchange device 1J, and the opposite side is defined as a front side of the heat exchange device 1J. The right side when the heat exchange device 1J is viewed from the front side is defined as a right side of the heat exchange device 1J, and the opposite side is defined as a left side of the heat exchange device 1J. In the direction orthogonal to the front-rear direction and the left-right direction of the heat exchange device 1J, the side on which the second component 70J is disposed is defined as an upper side of the heat exchange device 1J, and the opposite side is defined as a lower side of the heat exchange device 1J. Note that these orientations do not limit the orientation of the heat exchange device of the disclosure at the time of use.

In Figs. 25 to 46, the front side corresponds to a positive direction on an X-axis, the rear side corresponds to a negative direction on the X-axis, the right side corresponds to the positive direction on a Y-axis, the left side corresponds to the negative direction on the Y-axis, the upper side corresponds to the positive direction on a Z-axis, and the lower side corresponds to the negative direction on the Z-axis.

The second component 70J is attached to the heat exchange main body portion 10A and the first component 60J so as to be rotatable about an axis A. The axis A is substantially parallel to the vertical direction.

The O-ring 50 is interposed between the first component 60J and the second component 70J.

As illustrated in Fig. 27, the heat exchange device 1J has a lower main surface BS1. The lower main surface BS1 of the heat exchange device 1J has a planar shape.

The dimensions of the heat exchange device 1J are not particularly limited, and can be selected according to the application or the like of the heat exchange device 1J. For example, an area of the lower main surface BS1 of the heat exchange device 1J may be in the range of 50 cm² to 5,000 cm². For example, a thickness of the heat exchange device 1J in the vertical direction may be within a range of 1 mm to 50 mm.

### (9.1) Heat Exchange Main Body Portion

The heat exchange main body portion 10A according to the ninth embodiment is similar to the heat exchange main body portion 10A according to the first embodiment.

### (9.2) First Component

The first component 60J covers the through-hole HA.

As illustrated in Fig. 26, the first component 60J has a joint member 20J and a resin fixing portion 30J. The joint member 20J does not include the resin fixing portion 30J. The resin fixing portion is an example of a resin sealing portion.

### (9.2.1) Joint Member

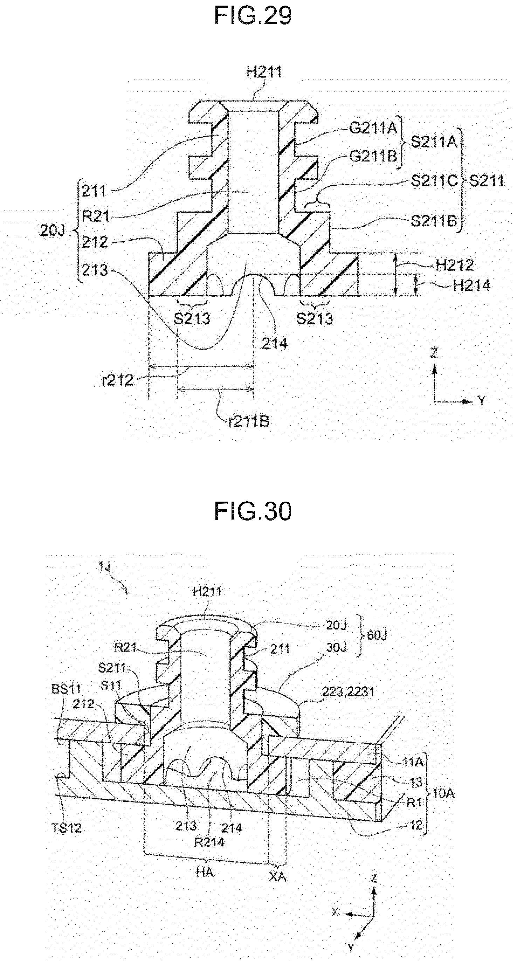

The joint member 20J is a molded body for supplying or discharging the cooling medium. As illustrated in Figs. 28 and 29, the joint member 20J has a first connecting portion 211, a projecting portion 212, a first hollow portion R21, and a main body portion 213. The first connecting portion 211, the projecting portion 212, and the main body portion 213 are integrated. The first connecting portion is an example of a protruding portion. The first hollow portion is an example of a hollow portion.

As illustrated in Fig. 29, the main body portion 213 is located at a lower portion of the joint member 20J in the vertical direction and at a central portion in the plane direction. The plane direction indicates a direction orthogonal to the vertical direction.

The main body portion 213 has a contact surface S213. The contact surface S213 comes into contact with the upper main surface TS12 of the lower metal member 12 in the heat exchange device 1J. The main body portion 213 firmly supports the first connecting portion 211 by the contact surface S213 coming into contact with the upper main surface TS12.

The second component 70J is connected to the first connecting portion 211. As illustrated in Fig. 30, the first connecting portion 211 protrudes upward from the main body portion 213 to the outside of the heat exchange main body portion 10A via the through-hole HA. As illustrated in Fig. 28, the first connecting portion 211 has a substantially cylindrical shape. The first connecting portion 211 of the joint member 20J has a first opening H211. A cooling medium is supplied to or discharged from the first opening H211. The first opening H211 faces upward.

As shown in Fig. 29, the outer peripheral surface S211 of the first connecting portion 211 has a distal end side outer peripheral surface S211A, a proximal end side outer peripheral surface S211B, and a step surface S211C. The proximal end side outer peripheral surface S211B has a diameter larger than that of the distal end side outer peripheral surface S211A. The step surface S211C couples the distal end side outer peripheral surface S211A and the proximal end side outer peripheral surface S211B. The step surface S211C is orthogonal to the vertical direction. As illustrated in Fig. 28, the distal end side outer peripheral surface S211A, the proximal end side outer peripheral surface S211B, and the step surface S211C are formed over an entire periphery of the outer peripheral surface S211 of the first connecting portion 211. The shape of the step surface S211C viewed from above to below is a ring shape.

The distal end side outer peripheral surface S211A has an upper annular fitting groove G211A and a lower annular fitting groove G211B. The upper annular fitting groove G211A is located above the lower annular fitting groove G211B. Each of the upper annular fitting groove G211A and the lower annular fitting groove G211B is formed over the entire periphery of the outer peripheral surface S211 of the joint member 20J.

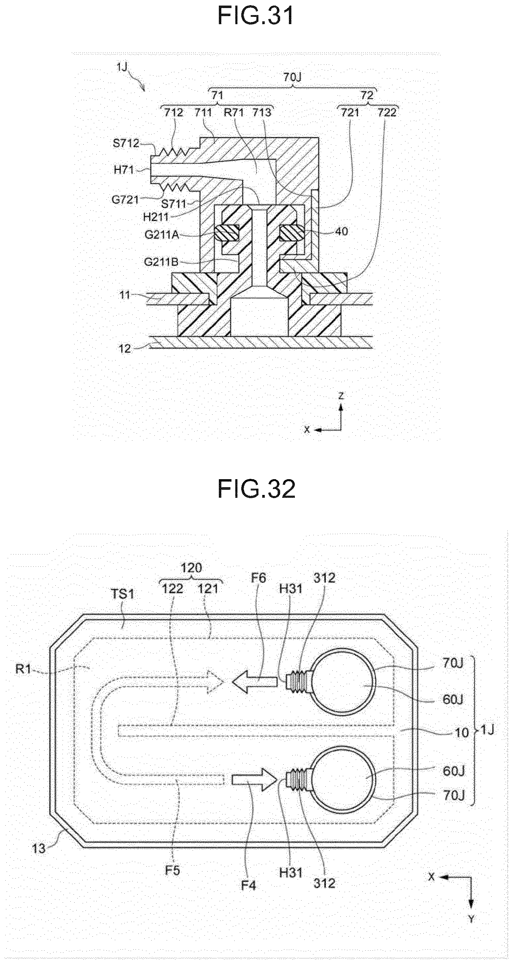

The O-ring 50 is fitted into the upper annular fitting groove G211A. An engagement protrusion portion 322 of the first component 60J described later with reference to Fig. 31 is engaged with the lower annular fitting groove G211B.

As illustrated in Fig. 30, the first hollow portion R21 is formed to connect the opening H211 and the internal flow path R1 of the heat exchange main body portion 10A. The first hollow portion R21 is formed along the vertical direction inside the first connecting portion 211.

As illustrated in Fig. 29, the projecting portion 212 projects from the main body portion 213 with respect to the outer peripheral surface S211 of the first connecting portion 211. The projecting portion 212 is formed over the entire periphery of the outer peripheral surface S211 of the first connecting portion 211. The shape of the projecting portion 212 viewed from above to below is a ring shape. As illustrated in Fig. 30, the projecting portion 212 is in contact with the lower main surface BS11 of the upper metal member 11A and the upper main surface TS12 of the lower metal member 12. That is, the projecting portion 212 is directly sandwiched between the upper metal member 11A and the lower metal member 12.

A radius r212 (see Fig. 29) of the projecting portion 212 can be appropriately adjusted according to the application of the heat exchange device 1J. For example, from the viewpoint of airtightness of the heat exchange device 1J, the radius r212 of the projecting portion 212 is larger than a radius r211B (see Fig. 29) of the portion corresponding to the proximal end side outer peripheral surface S211B of the first connecting portion 211 by a third distance. The third distance is preferably 0.5 mm to 20.0 mm, and more preferably 2.0 mm to 10.0 mm.

As illustrated in Fig. 30, the projecting portion 212 and the main body portion 213 have a notch portion 214. The notch portion 214 forms a flow path R214 with the upper main surface TS12 of the lower metal member 12 therebetween. The flow path R214 causes the first hollow portion R211 of the joint member 20J and the internal flow path R1 of the heat exchange main body portion 10A to communicate with each other.

In the vertical direction, a depth H214 (see Fig. 29) of the notch portion 214 is, for example, half a height H212 (see Fig. 29) of the projecting portion 212.

The projecting portion 212 has six notch portions 214. As illustrated in Fig. 28, each of the six notch portions 214 is formed at equal intervals over the entire periphery of the outer peripheral surface S212 of the projecting portion 212. A cross-sectional shape of the notch portion 214 is an arch shape.

A material of the joint member 20J is a resin. That is, the outer peripheral surface S211 of the first connecting portion 211 is made of a resin. The outer peripheral surface S211 of the first connecting portion 211 of the joint member 20J and the resin fixing portion 30J are fused. Therefore, as compared with a case where the joint member 20J is made of a metal, it is possible to cope with complication of a shape, weight reduction of a device, cost reduction, and the like.

The resin constituting the joint member 20J is not particularly limited, and may be the same as that exemplified as the resin constituting the joint member 20A according to the first embodiment.

### (9.2.2) Resin Fixing Portion

The resin fixing portion 30J is fixed to the upper metal member 11A. As illustrated in Fig. 30, the resin fixing portion 30J seals a gap between the inner peripheral surface S11 of the through-hole HA of the upper metal member 11A and the outer peripheral surface S211 of the joint member 20J. In other words, the gap between the inner peripheral surface S11 of the through-hole HA and the outer peripheral surface S211 of the joint member 20J is filled with the resin fixing portion 30J.

The resin fixing portion 30J has a covering portion 223. The covering portion 223 of the resin fixing portion 30J covers the periphery of the through-hole HA of the upper main surface TS11 of the upper metal member 11A. The covering portion 223 of the resin fixing portion 30J has a first covering portion 2231. The first covering portion 2231 covers the first region XA of the upper main surface TS11 of the upper metal member 11A. The first region XA indicates a region of the upper main surface TS11 of the upper metal member 11A facing the projecting portion 212 of the joint member 20J. The first covering portion 2231 is formed over the entire periphery of the through-hole HA. The shape of the covering portion 231 viewed from above to below is a ring shape.

A thickness of the first covering portion 2311 in the vertical direction can be appropriately adjusted according to the application of the heat exchange device 1J. For example, the thickness of the first covering portion 2311 is preferably 0.5 mm to 6.0 mm, and more preferably 1.0 mm to 4.0 mm from the viewpoint of airtightness of the heat exchange device 1J.

The sealing fixing surface is subjected to a roughening treatment in the same manner as in the first embodiment.

The resin fixing portion 30J is formed by injection molding. A material of the resin fixing portion 30J is a resin having compatibility with the resin constituting the joint member 20J. Accordingly, the resin fixing portion 30J and the outer peripheral surface S211 of the first connecting portion 211 of the joint member 20J are fused. The main component of the resin constituting the resin fixing portion 30J is preferably the same as the resin constituting the joint member 20J.

### (9.3) Second Component

The second component 70J is connected to the first component 60J. As illustrated in Fig. 31, the second component 70J includes a main body portion 71 and a lid portion 72. The lid portion 72 is attached to the main body portion 71.

The main body portion 71 has a housing portion 711, a second connecting portion 712, a fitting recess 713, and a second hollow portion R71.

The housing portion 711 is a substantially cylindrical object.

The second connecting portion 712 is formed to be connected with an external supply unit. The external supply unit supplies the cooling medium to the heat exchange device 1J. The second connecting portion 712 is located at an upper portion of the housing portion 711. The second connecting portion 712 protrudes in a direction orthogonal to the vertical direction with respect to an outer peripheral surface S711 of the housing portion 711. The second connecting portion 712 has a second opening H71. The cooling medium is supplied from the external supply unit or discharged from the external discharge unit through the second opening H71 of the second component 70J. On the outer peripheral surface S712 of the second connecting portion 712 of the second component 70J, a connecting groove G712 for fixing the external supply unit or discharge unit is formed.

The lid portion 72 is fitted into the fitting recess 713. The fitting recess 713 is formed so as to be located on the side opposite to the second connecting portion 712 in the outer peripheral surface S711 of the housing portion 711.

The second hollow portion R71 causes the second opening H71 and the first opening H211 of the first connecting portion 211 of the joint member 20J to communicate with each other. The first hollow portion R211 is formed inside the second connecting portion 712 and the housing portion 711.

The lid portion 72 has a fitting portion 721 and an engagement protrusion portion 722. The fitting portion 721 is fitted into the fitting recess 713 of the main body portion 71. The engagement protrusion portion 722 of the second component 70J engages with the lower annular fitting groove G211B of the joint member 20J when the fitting portion 721 is fitted into the fitting recess 713 of the main body portion 71. Accordingly, the second component 70J is rotatable with respect to the joint member 20J along the lower annular fitting groove G211B, that is, about the axis A (see Fig. 25).

A material of the second component 70J is not particularly limited, and is, for example, a metal or a resin.

The resins constituting the pair of second components 70J may be the same as or different from each other.

### (9.4) O-Ring

The O-ring 50 seals a gap between the first component 60J and the second component 70J. The O-ring 50 prevents leakage of a cooling medium or intrusion of foreign matter from the outside through a gap between the second component 70J and the first connecting portion 211 of the joint member 20J.

### (9.5) Flow of Cooling Medium

The heat exchange device 1J is installed and used such that, for example, the lower main surface BS1 of the heat exchange device 1J comes into contact with the heating element. At this time, an external supply unit is coupled to one second component 70J. An external discharge unit is coupled to the other second component 70J. The heat of the heating element is conducted to the cooling medium filled in the internal flow path R1 via the heat exchange main body portion 10A.

As illustrated in Fig. 32, the cooling medium is supplied from the external supply unit to the second opening H71 of the one second component 70J along a flow direction F4. The cooling medium moves to the internal flow path R1 via the second hollow portion R71 of the one second component 70J, the first hollow portion R211 of the one joint member 20J, and the flow path R214. Most of the cooling medium that has reached the internal flow path R1 moves in the internal flow path R1 toward the other joint member 20J along a flow direction F5. At this time, the cooling medium is warmed by heat exchange with the heat exchange main body portion 10A. On the other hand, the heat exchange main body portion 10A is cooled by heat exchange with the cooling medium. Next, the cooling medium moves to the second opening H71 via the flow path R214 of the other joint member 20J, the first hollow portion R211, and the second hollow portion R71 of the other second component 70J, and is discharged from the second opening H71 to the external discharge unit along a flow direction F6. In this manner, the cooling medium absorbs heat from the heating element inside the heat exchange device 1J and is discharged to the outside of the heat exchange device 1J. That is, the heat exchange device 1J promotes heat dissipation of the heating element.

### (9.6) Method for Manufacturing Heat Exchange Device

The method for manufacturing the heat exchange device 1J includes a preparation step, a first roughening step, a second roughening step, an insert step, and a sealing step. The preparation step, the insert step, and the sealing step are executed in this order. The first roughening step and the second roughening step are not particularly limited as long as they are executed before the sealing step. The first roughening step may be executed simultaneously with the second roughening step, may be executed after the second roughening step is executed, or may be executed before the second roughening step is executed.

### (9.7.1) Preparation Step

In the preparation step, the joint member 20J is prepared. That is, the joint member 20J is molded in advance before the sealing step is executed. Therefore, the joint member 20J can be molded into a more complicated shape as compared with a case of being injection molded in the sealing step. As a result, similarly to the first embodiment, the heat exchange device 1J that can be used in various fields can be obtained.

A method for preparing the joint member 20J is not particularly limited, and can be appropriately adjusted according to the application of the heat exchange device 1J. Examples of the method for preparing the joint member 20J include resin molding. Examples of the resin molding include injection molding, cast molding, press molding, insert molding, extrusion molding, and transfer molding.

### (9.7.2) First Roughening Step

The first roughening step is executed in the same manner as the first roughening step according to the first embodiment.

### (9.7.3) Second Roughening Step

The second roughening step is executed in the same manner as the second roughening step according to the first embodiment.

### (9.7.4) Insert Step

In the insert step, the joint member 20J is disposed inside the heat exchange main body portion 10A, and the first connecting portion 211 of the joint member 20J protrudes toward the outside of the heat exchange main body portion 10A via the through-hole HA. In the disclosure, "the joint member 20J is disposed inside the heat exchange main body portion 10A" indicates that a part of the joint member 20J is accommodated in the heat exchange main body portion 10A.

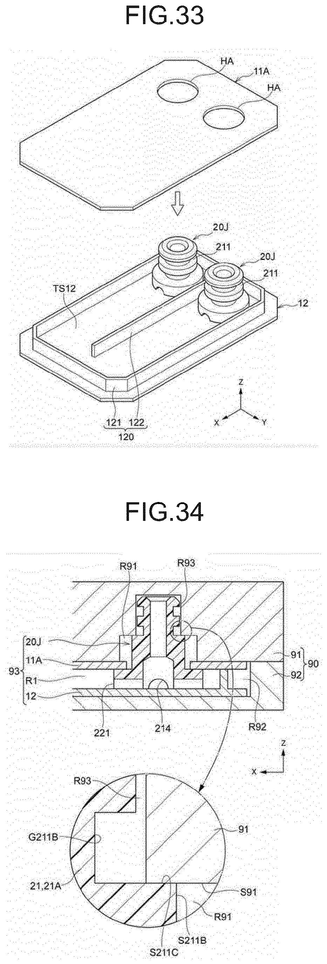

Specifically, as shown in Fig. 33, the insert step is executed in the same manner as the insert step according to the first embodiment. Accordingly, an insert is obtained. As described above, even when the size of the projecting portion 212 of the joint member 20J is larger than the size of the through-hole HA, the joint member 20J can be disposed inside the heat exchange main body portion 10A.

### (9.7.5) Sealing Step

In the sealing step, the resin fixing portion 30J is formed in a gap between the inner peripheral surface S11 of the through-hole HA and the outer peripheral surface S211 of the first connecting portion 211, thereby sealing the gap and forming the resin joint portion 13. Accordingly, the resin fixing portion 30J and the resin joint portion 13 are formed more efficiently than a case where each of the resin fixing portion 30J and the resin joint portion 13 is formed in separate steps. Even when the joint member 20J is not joined to the heat exchange main body portion 10A by brazing or welding, the heat exchange device 1J having excellent airtightness can be obtained.

Specifically, in the sealing step, the resin fixing portion 30J is formed in a gap between the inner peripheral surface S11 of the through-hole HA and the outer peripheral surface S211 of the first connecting portion 211 of the joint member 20J by injection molding, and the resin joint portion 13 is formed in the side surface recess R100.

An injection molding machine is used for the injection molding. The injection molding machine includes an injection molding mold 90, an injection device, and a mold clamping device. As illustrated in Fig. 34, the injection molding mold 90 includes a movable-side mold 91 and a fixed-side mold 92. The fixed-side mold 92 is fixed to the injection molding machine. The movable-side mold 91 is movable with respect to the fixed-side mold 92. The injection device injects the resin melt into a sprue of the injection molding mold 90 at a predetermined injection pressure. The mold clamping device clamps the movable-side mold 91 at a high pressure so that the movable-side mold is not opened by a filling pressure of the resin melt.

First, the movable-side mold 91 is opened, the insert 93 is placed on the fixed-side mold 92, the movable-side mold 91 is closed, and the mold is clamped. That is, the insert 93 is accommodated in the injection molding mold 90. Accordingly, the first space R91, the second space R92, and the third space R93 are formed between the insert 93 and the injection molding mold 90. The first space R91 indicates a space where the resin fixing portion 30J is formed. The second space R92 indicates a space where the resin joint portion 13 is formed. The third space R93 indicates a space for accommodating the first connecting portion 211 in the injection molding mold 90. Next, the injection molding machine fills the first space R91 and the second space R92 with the resin melt at a high pressure.

At this time, the projecting portion 212 of the joint member 20J is in contact with the lower main surface BS11 of the upper metal member 11A and the upper main surface TS12 of the lower metal member 12. That is, the projecting portion 212 functions as a support of the upper metal member 11A. Accordingly, even when the injection pressure is applied downward to the upper metal member 11A, the upper metal member 11A is hardly deformed. Further, a path through which the resin melt intrudes into the internal flow path R1 of the heat exchange main body portion 10A is blocked by the projecting portion 212. Therefore, the projecting portion 212 suppresses intrusion of the resin melt into the internal flow path R1.

A part of the transfer side surface 91S of the movable-side mold 91 comes into contact with the step surface S211C. That is, the path connecting the first space R91 and the third space R93 is blocked by the contact between the transfer side surface 91S and the step surface S211C. Therefore, even when the first space R91 is filled with the resin melt, the molten resin in the first space R91 does not move into the third space R93. As a result, the generation of burrs caused by the intrusion of the resin melt into the third space R93 is suppressed. That is, the heat exchange device 1J is obtained in which an unnecessary resin shape such as burrs is not formed.

Next, the resin melt in the injection molding mold 90 is cooled and solidified. Accordingly, the resin fixing portion 30J and the resin joint portion 13 are formed in the insert 93. That is, the heat exchange device 1J is obtained.

### (9.8) Action and Effect

As described with reference to Figs. 25 to 34, in the ninth embodiment, the heat exchange device 1J includes the heat exchange main body portion 10A, the pair of first components 60J, and the pair of second components 70J. The heat exchange main body portion 10A has the upper metal member 11A including the through-hole HA. The first component 60J covers the through-hole HA. The second component 70J is connected to the first component 60J. The heat exchange main body portion 10A further has the internal flow path R1. The first component 60J has the first connecting portion 211, the first hollow portion R21, and the resin fixing portion 30J. The first connecting portion 211 includes the first opening H211. The second component 70J is connected to the first connecting portion 211. The resin fixing portion 30J is fixed to the upper metal member 11A. The second component 70J has the second connecting portion 712 and the second hollow portion R71. The second connecting portion 712 includes the second opening H71. The second hollow portion R71 causes the second opening H71 and the first opening H211 to communicate with each other.

Accordingly, the heat exchange device 1J can prevent leakage of the cooling medium or intrusion of foreign matter from the outside through the gap between the first component 60J and the upper metal member 11A. That is, the heat exchange device 1J is excellent in airtightness even when the first component 60J for supply and discharge is not joined to the heat exchange main body portion 10A by brazing or welding.

As described with reference to Figs. 25 to 34, in the ninth embodiment, the heat exchange device 1J includes the O-ring 50.

Accordingly, the heat exchange device 1J can more reliably prevent leakage of the cooling medium or intrusion of foreign matter from the outside through the gap between the first component 60J and the second component 70J than a case where the heat exchange device 1J does not include the O-ring.

As described with reference to Figs. 25 to 34, in the ninth embodiment, the pair of sealing fixing surfaces is preferably subjected to the roughening treatment. That is, the pair of sealing fixing surfaces has fine unevenness.

Accordingly, the resin fixing portion 30J is firmly fixed to the upper metal member 11A by the anchor effect as compared with a case where the roughening treatment is not performed. As a result, the heat exchange device 1J can maintain airtightness for a long period of time.

As described with reference to Figs. 25 to 34, in the ninth embodiment, the first component 60J has the joint member 20J. The joint member 20J includes the first connecting portion 211 and the first hollow portion R21. The joint member 20J does not include the resin fixing portion 30J. The first connecting portion 211 protrudes toward the outside of the heat exchange main body portion 10A via the through-hole HA. The resin fixing portion 30J seals the gap between the inner peripheral surface S11 of the through-hole HA and the outer peripheral surface S211 of the first connecting portion 211. Accordingly, the heat exchange device 1J can prevent leakage of the heat exchange medium or intrusion of foreign matter from the outside through the gap between the through-hole HA and the first connecting portion 211. That is, the heat exchange device 1J is excellent in airtightness even when the joint member 20J is not joined to the heat exchange main body portion 10A by brazing or welding.

As described with reference to Figs. 25 to 34, in the ninth embodiment, the joint member 20J has the projecting portion 212. The projecting portion 212 is in contact with the lower main surface BS11 of the upper metal member 11A and the upper main surface TS12 of the lower metal member 12.

Accordingly, the projecting portion 212 functions as a support of the upper metal member 11A. Therefore, even when a pressing force is applied downward to the upper metal member 11A, the upper metal member 11A is hardly deformed. For example, when the resin fixing portion 30J is formed by injection molding, the projecting portion 212 serves as a support of the upper metal member 11A against the injection pressure, so that the upper metal member 11A is hardly deformed. As a result, the pressure loss of the cooling medium flowing through the internal flow path R1 is reduced. That is, the heat exchange device 1J can maintain a sealability for a longer period of time.

As described with reference to Figs. 25 to 34, in the ninth embodiment, the resin fixing portion 30J has the covering portion 223.

Accordingly, the contact area between the resin fixing portion 30J and the upper metal member 11A is larger than that in a case where the resin fixing portion 30J does not have the covering portion 223. Therefore, the resin fixing portion 30J is more firmly fixed to the upper metal member 11A than a case where the resin fixing portion 30J does not have the covering portion 223. As a result, the heat exchange device 1J can maintain airtightness for a long period of time.

As described with reference to Figs. 25 to 34, in the ninth embodiment, the covering portion 223 has the first covering portion 2231.

Accordingly, even when the resin fixing portion 30J is injection molded and the thickness of the upper metal member 11A is relatively thin, the occurrence of deformation of the upper metal member 11A due to the injection pressure is suppressed. Further, the contact area between the resin fixing portion 30J and the upper metal member 11A is larger than a case where the resin fixing portion 30J does not have the first covering portion 2231. Therefore, the resin fixing portion 30J is more firmly fixed to the upper metal member 11A. As a result, the heat exchange device 1J can maintain airtightness for a longer period of time.

As described with reference to Figs. 25 to 34, in the ninth embodiment, the outer peripheral surface S211 of the first connecting portion 211 has the distal end side outer peripheral surface S211A, the proximal end side outer peripheral surface S211B, and the step surface S211C. The covering portion 223 covers only the proximal end side outer peripheral surface S211B of the outer peripheral surface S211 of the first connecting portion 211.

Accordingly, when the resin fixing portion 30J is formed by insert molding, which is one type of injection molding, the step surface S211C can suppress the formation of burrs. As a result, the heat exchange device 1J is excellent in an appearance.

As described with reference to Figs. 25 to 34, in the ninth embodiment, the projecting portion 212 has the notch portion 214.

Accordingly, the joint member 20J does not have the notch portion 214, and can form a passage of a cooling medium having a larger volume than a case where the hollow portion R21 and the internal flow path R1 directly communicate with each other. Therefore, the pressure loss of the cooling medium flowing through the internal flow path R1 is reduced. As a result, the heat exchange device 1J can efficiently cause the cooling medium to flow through the internal flow path R1.

As described with reference to Figs. 25 to 34, in the ninth embodiment, the cross-sectional shape of the notch portion 214 is an arch shape.

Accordingly, even when a pressing force is applied downward to the upper metal member 11A, the flow path R214 is less likely to be deformed as compared with a case of not having an arch shape. Therefore, the pressure loss of the cooling medium flowing through the internal flow path R1 is reduced. As a result, the heat exchange device 1J can cause the cooling medium to flow through the internal flow path R1 more efficiently.

As described with reference to Figs. 25 to 34, in the ninth embodiment, the outer peripheral surface S211 of the first connecting portion 211 is made of a resin. The outer peripheral surface S211 of the first connecting portion 211 and the resin fixing portion 30J are fused.

Accordingly, the resin fixing portion 30J and the joint member 20J are firmly fixed to each other. As a result, the heat exchange device 1J can maintain airtightness for a longer period of time.

As described with reference to Figs. 25 to 34, in the ninth embodiment, the resin fixing portion 30J is formed by injection molding.

Accordingly, the resin fixing portion 30J enters the gap of the fine uneven portions of the pair of sealing fixing surfaces. Therefore, the resin fixing portion 30J is firmly fixed to the upper metal member 11A. As a result, the heat exchange device 1J can maintain airtightness for a longer period of time.

### (10) Tenth Embodiment

A heat exchange device 1K according to a tenth embodiment is different from the heat exchange device 1J according to the ninth embodiment mainly in that the through-hole is covered with a joint member so that the through-hole is not exposed.

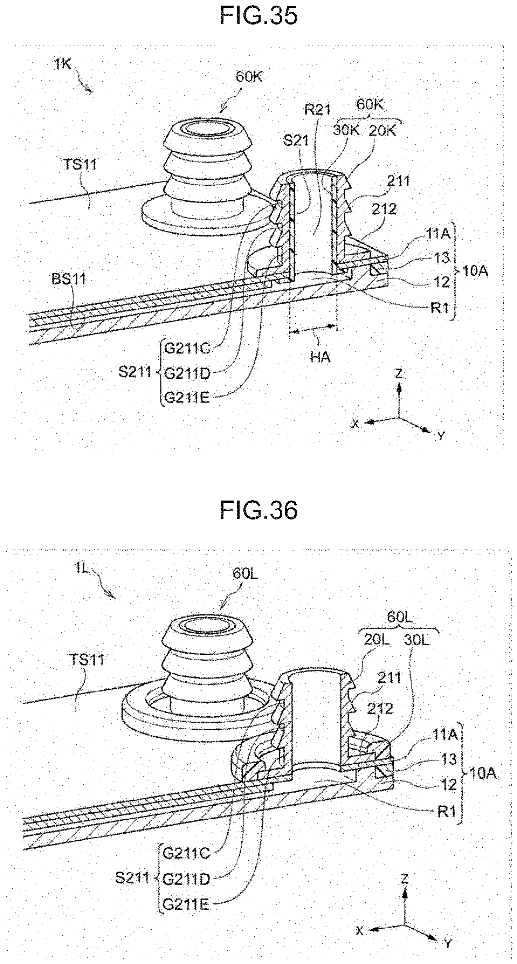

As illustrated in Fig. 35, the heat exchange device 1K includes a heat exchange main body portion 10A, a pair of first components 60K, a pair of second components 70J (see Fig. 26), and two O-rings 50 (see Fig. 26).

The first component 60K has a joint member 20K and a resin fixing portion 30K. The joint member 20K does not include the resin fixing portion 30K.

The joint member 20K has a first connecting portion 211, a projecting portion 212, and a first hollow portion R21. The first connecting portion 211 and the projecting portion 212 are integrated.

As illustrated in Fig. 35, the outer peripheral surface S211 of the first connecting portion 211 has an upper annular mounting groove G211C, a middle annular mounting groove G211D, and a lower annular mounting groove G211E. The upper annular mounting groove G211C is located above the middle annular mounting groove G211D. The lower annular mounting groove G211E is located below the middle annular mounting groove G211D. Each of the upper annular mounting groove G211C, the middle annular mounting groove G211D, and the lower annular mounting groove G211E is formed over the entire periphery of the outer peripheral surface S211 of the joint member 20K.

The engagement protrusion portion 722 of the lid portion 72 of the second component 70J is engaged with any one of the upper annular mounting groove G211C, the middle annular mounting groove G211D, and the lower annular mounting groove G211E. Accordingly, the second component 70J is connected to the first connecting portion 211 of the joint member 20K.

The projecting portion 212 is in contact only with the upper main surface TS11 of the upper metal member 11A. In other words, the joint member 20K is located on the upper main surface TS11 of the upper metal member 11A and covers the through-hole HA. The through-hole HA is not exposed.

The resin fixing portion 30K is fixed to the lower main surface BS11 of the upper metal member 11A. Specifically, the resin fixing portion 30K covers the periphery of the through-hole HA of the lower main surface BS11 of the upper metal member 11A and the entire inner peripheral surface S21 of the first hollow portion R21 of the first connecting portion 211 of the joint member 20K.

The heat exchange device 1K according to the tenth embodiment has the same action and effect as those of the heat exchange device 1J according to the ninth embodiment.

### (11) Eleventh Embodiment

A heat exchange device 1L according to an eleventh embodiment is different from the heat exchange device 1J according to the ninth embodiment mainly in that the through-hole is covered with a joint member so that the through-hole is not exposed.

As illustrated in Fig. 36, the heat exchange device 1L includes a heat exchange main body portion 10A, a pair of first components 60L, a pair of second components 70J (see Fig. 26), and two O-rings 50 (see Fig. 26).

The first component 60L has a joint member 20L and a resin fixing portion 30L. The joint member 20L does not include the resin fixing portion 30L.

As illustrated in Fig. 36, the outer peripheral surface S211 of the first connecting portion 211 of the joint member 20L has an upper annular mounting groove G211C, a middle annular mounting groove G211D, and a lower annular mounting groove G211E.

The projecting portion 212 of the joint member 20L is in contact only with the upper main surface TS11 of the upper metal member 11A.

The resin fixing portion 30L is fixed to the upper main surface TS11 of the upper metal member 11A. Specifically, the resin fixing portion 30L covers the periphery of the projecting portion 212 of the upper main surface TS11 of the upper metal member 11A and the peripheral edge portion of the projecting portion 212.

The heat exchange device 1L according to the eleventh embodiment has the same action and effect as those of the heat exchange device 1J according to the ninth embodiment.

### (12) Twelfth Embodiment

A heat exchange device 1M according to a twelfth embodiment is different from the heat exchange device 1J according to the ninth embodiment mainly in that the through-hole is covered with a joint member so that the through-hole is not exposed.

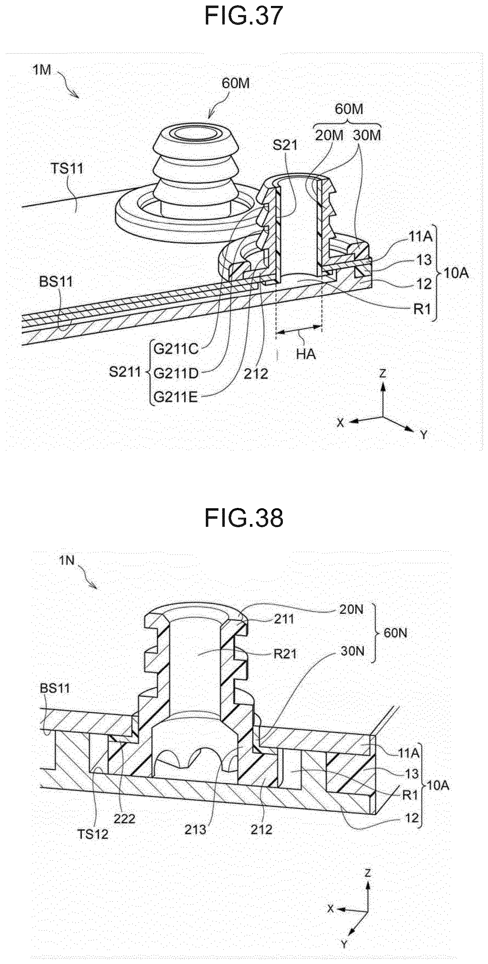

As illustrated in Fig. 37, the heat exchange device 1M includes a heat exchange main body portion 10A, a pair of first components 60M, a pair of second components 70J (see Fig. 26), and two O-rings 50 (see Fig. 26).

The first component 60M has a joint member 20M and a resin fixing portion 30M. The joint member 20M does not include the resin fixing portion 30M.

As illustrated in Fig. 37, the outer peripheral surface S211 of the first connecting portion 211 of the joint member 20M has an upper annular mounting groove G211C, a middle annular mounting groove G211D, and a lower annular mounting groove G211E.

The projecting portion 212 of the joint member 20M is in contact only with the upper main surface TS11 of the upper metal member 11A.

The resin fixing portion 30M is fixed to the upper main surface TS11 and the lower main surface BS11 of the upper metal member 11A. Specifically, the resin fixing portion 30M covers the periphery of the through-hole HA of the lower main surface BS11 of the upper metal member 11A, the entire inner peripheral surface S21 of the first hollow portion R21 of the first connecting portion 211 of the joint member 20M, the periphery of the projecting portion 212 of the upper main surface TS11 of the upper metal member 11A, and the peripheral edge portion of the projecting portion 212.

The heat exchange device 1M according to the twelfth embodiment has the same action and effect as those of the heat exchange device 1J according to the ninth embodiment.

### (13) Thirteenth Embodiment

A heat exchange device 1N according to a thirteenth embodiment is different from the heat exchange device 1J according to the ninth embodiment mainly in that the projecting portion is not in direct contact with the lower main surface of the upper metal member.

As illustrated in Fig. 38, the heat exchange device 1N includes a heat exchange main body portion 10A, a pair of first components 60N, a pair of second components 70J (see Fig. 26), and two O-rings 50 (see Fig. 26).

The first component 60N includes a joint member 20N and a resin fixing portion 30N. The joint member 20N does not include the resin fixing portion 30N.

The joint member 20N has a first connecting portion 211, a first hollow portion R21, a projecting portion 212, and a main body portion 213. As illustrated in Fig. 38, the projecting portion 212 of the joint member 20N is in contact only with the upper main surface TS12 of the lower metal member 12. That is, the projecting portion 212 is not in contact with the lower main surface BS11 of the upper metal member 11A.

The resin fixing portion 30N has a filling portion 222. The filling portion 222 fills a gap between the projecting portion 212 and the lower main surface BS11 of the upper metal member 11A. That is, the projecting portion 212 is indirectly sandwiched between the upper metal member 11A and the lower metal member 12. The resin fixing portion 30N does not have the covering portion 223 (see Fig. 30).

The heat exchange device 1N according to the thirteenth embodiment has the same action and effect as those of the heat exchange device 1J according to the ninth embodiment.

### (14) Fourteenth Embodiment

A heat exchange device 1P according to a fourteenth embodiment is different from the heat exchange device 1J according to the ninth embodiment mainly in that the covering portion of the resin fixing portion further covers the outside of the first region of the upper main surface of the upper metal member.

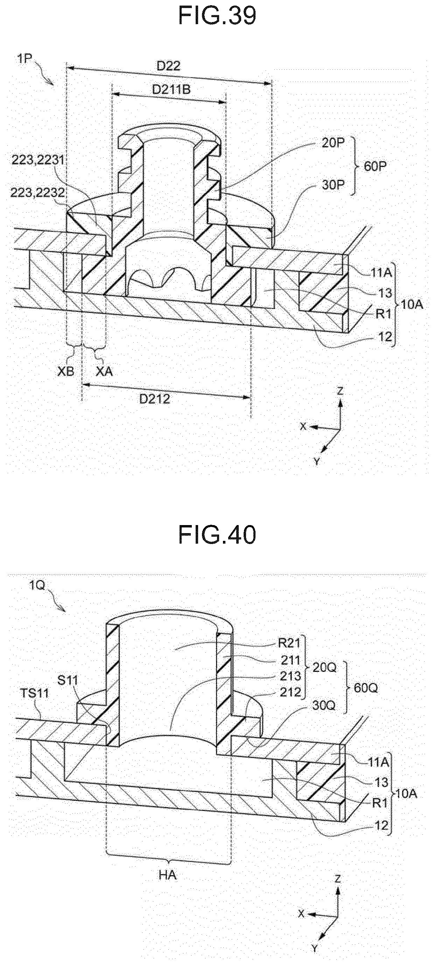

As illustrated in Fig. 39, the heat exchange device 1P includes a heat exchange main body portion 10A, a pair of first components 60P, a pair of second components 60J (see Fig. 26), and two O-rings 50 (see Fig. 26).

The first component 60P has a joint member 20P and a resin fixing portion 30P. The joint member 20P does not include the resin fixing portion 30P.

As illustrated in Fig. 39, the covering portion 223 of the resin fixing portion 30P has a first covering portion 2231 and a second covering portion 2232. The second covering portion 2232 covers the second region XB of the upper main surface TS11 of the upper metal member 11A. The second region XB indicates a region outside the first region XA of the upper main surface TS11 of the upper metal member 11A with respect to the through-hole HA. The first covering portion 2231 and the second covering portion 2232 are integrated. The shape of the resin fixing portion 30P viewed from above to below is a ring shape.

From the viewpoint of improving the joining strength of the resin fixing portion 30P to the upper metal member 11A, an upper limit of the diameter D22 (see Fig. 39) of the resin fixing portion 30P is preferably equal to or less than a value obtained by adding a numerical value three times the thickness of the upper metal member 11A in the vertical direction to a diameter D212 (see Fig. 39) of the projecting portion 212. The diameter D212 is twice the radius r212 (see Fig. 29) described in the ninth embodiment. When the upper limit of the diameter D22 of the resin fixing portion 30P is within the above range, the upper metal member 11A is less likely to be bent by the injection pressure when the resin fixing portion 30P is formed by insert molding, which is one type of injection molding. Therefore, the projecting portion 212 can further suppress intrusion of the resin melt into the internal flow path R1. On the other hand, the lower limit of the diameter D22 of the resin fixing portion 30P is preferably equal to or larger than a value obtained by adding 0.5 mm to a diameter D211B (see Fig. 39) of the portion corresponding to the proximal end side outer peripheral surface S211B of the first connecting portion 211. The diameter D211B is twice the radius r211B (see Fig. 29) described in the ninth embodiment.

As described with reference to Fig. 39, in the fourteenth embodiment, the covering portion 223 has the second covering portion 2232 that covers the second region XB. Accordingly, the contact area between the resin fixing portion 30P and the pair of sealing fixing surfaces is wider than that in the ninth embodiment. Therefore, the resin fixing portion 30P is more firmly fixed to the upper metal member 11A than in the ninth embodiment. As a result, the heat exchange device 1P can maintain airtightness for a longer period of time than in the ninth embodiment.

The heat exchange device 1P according to the fourteenth embodiment has the same action and effect as those of the heat exchange device 1J according to the ninth embodiment.

### (15) Fifteenth Embodiment

A heat exchange device 1Q according to a fifteenth embodiment is different from the heat exchange device 1J according to the ninth embodiment mainly in that a first component covers a through-hole.

As illustrated in Fig. 40, the heat exchange device 1Q includes a heat exchange main body portion 10A, a pair of first components 60Q, a pair of second components 70J (see Fig. 26), and two O-rings 50 (see Fig. 26).

The first component 60Q has a first connecting portion 211, a first hollow portion R21, a projecting portion 212, a main body portion 213, and a resin fixing portion 30Q. The first component 60Q is an injection-molded product. The first connecting portion 211, the first hollow portion R21, the projecting portion 212, the main body portion 213, and the resin fixing portion 30Q are integrated.

The first component 60Q covers the through-hole HA. Specifically, the first component 60Q is disposed on the upper main surface TS11 in a state where the through-hole HA is covered with the first component 60Q so as not to be exposed, and there is no gap between the resin fixing portion 30Q and the upper main surface TS11 of the upper metal member 11A.

As illustrated in Fig. 40, the first connecting portion 211 according to the fifteenth embodiment protrudes upward from the main body portion 213. The first connecting portion 211 has a cylindrical shape.

The projecting portion 212 according to the fifteenth embodiment is in contact only with the upper main surface TS 11 of the upper metal member 11A.

The resin fixing portion 30Q is fixed to the upper metal member 11A. Specifically, the resin fixing portion 30Q is fixed to the periphery of the through-hole HA of the upper main surface TS11 of the upper metal member 11A and the inner peripheral surface S11 of the through-hole HA.

The periphery of the through-hole HA of the upper main surface TS11 of the upper metal member 11A and the inner peripheral surface S11 of the through-hole HA are subjected to a roughening treatment in the same manner as in the first embodiment.

The heat exchange device 1Q according to the fifteenth embodiment has the same action and effect as those of the heat exchange device 1J according to the ninth embodiment.

### (16) Sixteenth Embodiment

A heat exchange device 1R according to a sixteenth embodiment is different from the heat exchange device 1J according to the ninth embodiment mainly in that each of the first connecting portion, the through-hole, and the covering portion has a substantially square shape.

The heat exchange device 1R includes a heat exchange main body portion 10A, a pair of first components 60R, a pair of second components 70J (see Fig. 26), and two O-rings 50 (see Fig. 26).

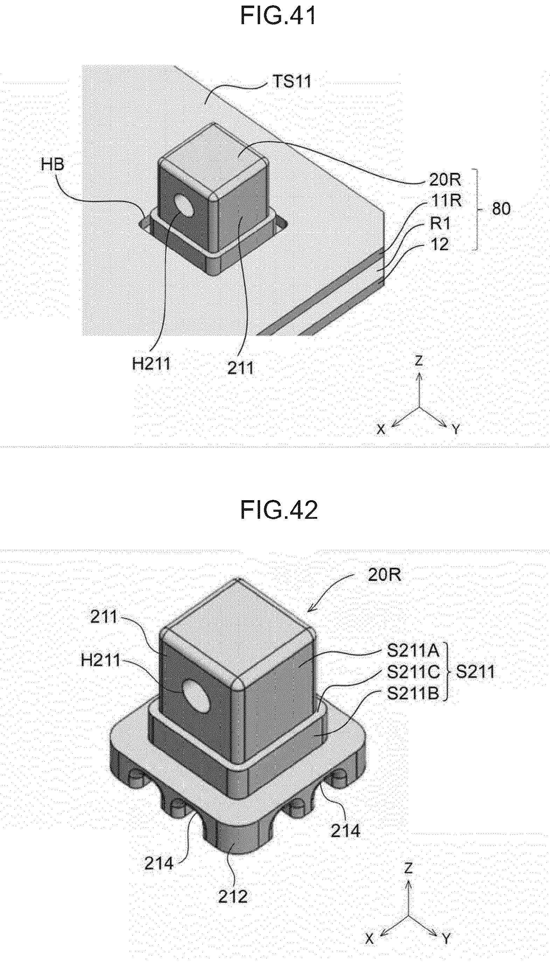

As illustrated in Fig. 41, the heat exchange main body portion 10R has an internal flow path R1, an upper metal member 11R, a lower metal member 12, and a resin joint portion 13. The upper metal member 11R has a through-hole HB. The shape of the through-hole HB viewed from above to below is a substantially square shape.

The first component 60R has a joint member 20R and a resin fixing portion 30R.

As illustrated in Fig. 42, the outer peripheral surface S211 of the first connecting portion 211 of the joint member 20R has a distal end side outer peripheral surface S211A, a proximal end side outer peripheral surface S211B, and a step surface S211C. The shape of the distal end side outer peripheral surface S211A viewed from above to below is substantially square. The shape of each of the proximal end side outer peripheral surface S211B and the step surface S211C viewed from above to below is a substantially square ring shape.

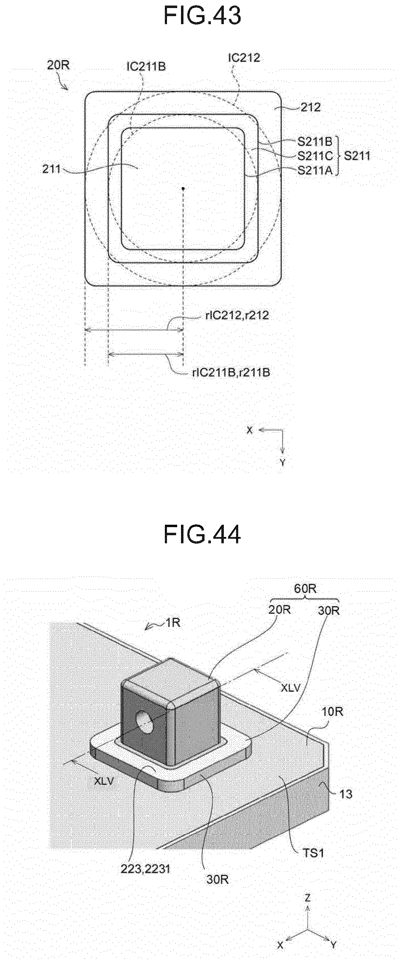

In the sixteenth embodiment, the shape of the projecting portion 212 viewed from above to below is a substantially square ring shape. As illustrated in Fig. 43, in a plane orthogonal to the vertical direction, a radius rIC212 of an inscribed circle IC212 of the projecting portion 212 is the same as the radius r212 (see Fig. 29) described in the ninth embodiment. In a plane orthogonal to the vertical direction, a radius rIC211B of an inscribed circle IC211B of the proximal end side outer peripheral surface S211B of the first connecting portion 211 is the same as the radius r211B (see Fig. 29) described in the ninth embodiment. For example, the radius rIC212 of the inscribed circle IC212 of the projecting portion 212 according to the sixteenth embodiment is preferably larger than the radius rIC211B by the third distance described in the ninth embodiment from the viewpoint of airtightness of the heat exchange device 1R.

The resin fixing portion 30R has a covering portion 223. The covering portion 223 has a first covering portion 2231. As illustrated in Fig. 44, the first covering portion 2231 is formed over the entire periphery of the through-hole HA. The shape of the covering portion 223 viewed from above to below is a substantially square ring shape.

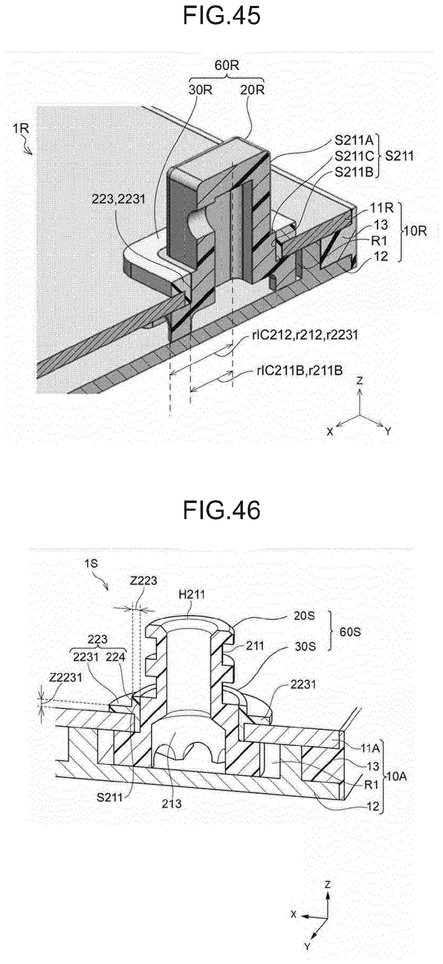

In the sixteenth embodiment, as described above, the radius rIC212 of the inscribed circle IC212 of the projecting portion 212 is the same as the radius r212 described in the ninth embodiment. That is, in the plane orthogonal to the vertical direction, a radius r2231 (see Fig. 45) of the inscribed circle of the first covering portion 2231 is also the same as the radius r212 described in the ninth embodiment. Therefore, the contact area between the first covering portion 2231 and the upper metal member 11R according to the sixteenth embodiment is larger than that of the ninth embodiment. As a result, the resin fixing portion 30R according to the sixteenth embodiment is more firmly fixed to the upper metal member 11R than the ninth embodiment.

The heat exchange device 1R according to the sixteenth embodiment has the same action and effect as those of the heat exchange device 1J according to the ninth embodiment.

### (17) Seventeenth Embodiment

A heat exchange device 1S according to a seventeenth embodiment is different from the heat exchange device 1J according to the ninth embodiment mainly in that a resin fixing portion has a step portion.

As illustrated in Fig. 46, the heat exchange device 1S includes a heat exchange main body portion 10A, a pair of first components 60S, a pair of second components 70J (see Fig. 46), and two O-rings 50 (see Fig. 46).

The first component 60S has a joint member 20S and a resin fixing portion 30S. The joint member 20S does not include the resin fixing portion 30S.

As illustrated in Fig. 46, the resin fixing portion 30S has a covering portion 223. The covering portion 223 of the resin fixing portion 30S according to the seventeenth embodiment has a first covering portion 2231.

The resin fixing portion 30S further has a step portion 224. The step portion 224 is located on the first connecting portion 211 side and on the upper side of the covering portion 223. The step portion 224 is formed over the entire periphery of the outer peripheral surface S211 of the first connecting portion 211. The covering portion 223 and the step portion 224 are integrated. That is, the step portion 224 protrudes upward from the covering portion 223 along the outer peripheral surface S211 of the first connecting portion 211. The shape of the step portion 224 viewed from above to below is a ring shape.

In the seventeenth embodiment, a thickness Z2231 (see Fig. 46) of the first covering portion 2231 in the vertical direction is substantially the same as a thickness Z223 (see Fig. 46) of the step portion 224 in the direction orthogonal to the vertical direction. In other words, a thickness of a portion of the resin fixing portion 30J above the upper main surface TS11 of the upper metal member 11A is substantially uniform. Accordingly, a resin amount of the resin fixing portion 30S can be reduced as compared with the resin fixing portion 30J (see Fig. 30) of the ninth embodiment. When the resin fixing portion 30J is formed by injection molding, the time required for cooling and solidifying the resin melt can be further shortened and a shrinkage stress generated at the time of cooling and solidifying the resin melt can be further reduced as compared with the resin fixing portion 30J (see Fig. 29) of the ninth embodiment.

Each of the thickness Z2231 (see Fig. 46) and the thickness Z223 (see Fig. 46) is preferably 0.5 mm to 6.0 mm, more preferably 1.0 mm to 4.0 mm, and particularly preferably 2.0 mm.

The heat exchange device 1S according to the seventeenth embodiment has the same action and effect as those of the heat exchange device 1J according to the ninth embodiment.

### (18) Eighteenth Embodiment

A heat exchange device 1T according to an eighteenth embodiment is used to promote heat dissipation of an external heating element. Examples of the heating element include those the same as those exemplified as the heating element according to the first embodiment.

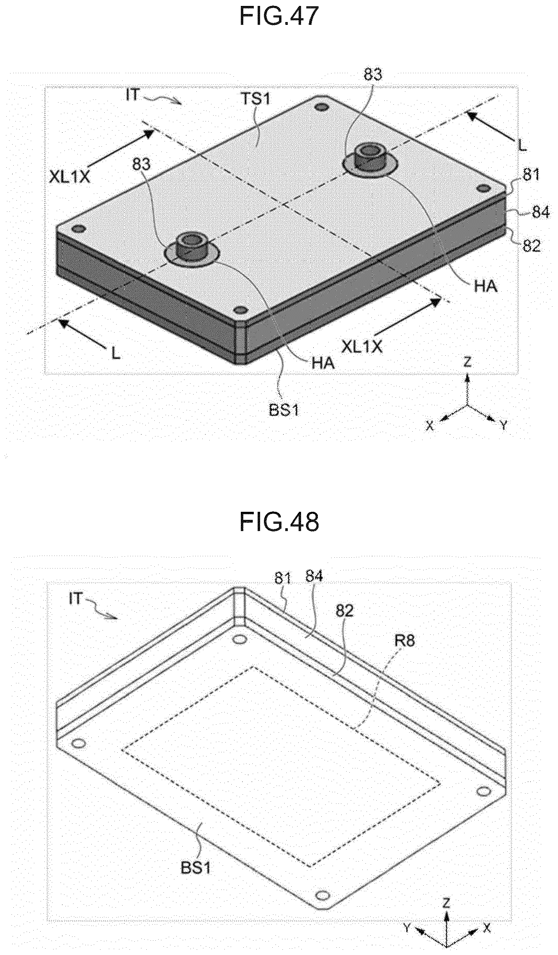

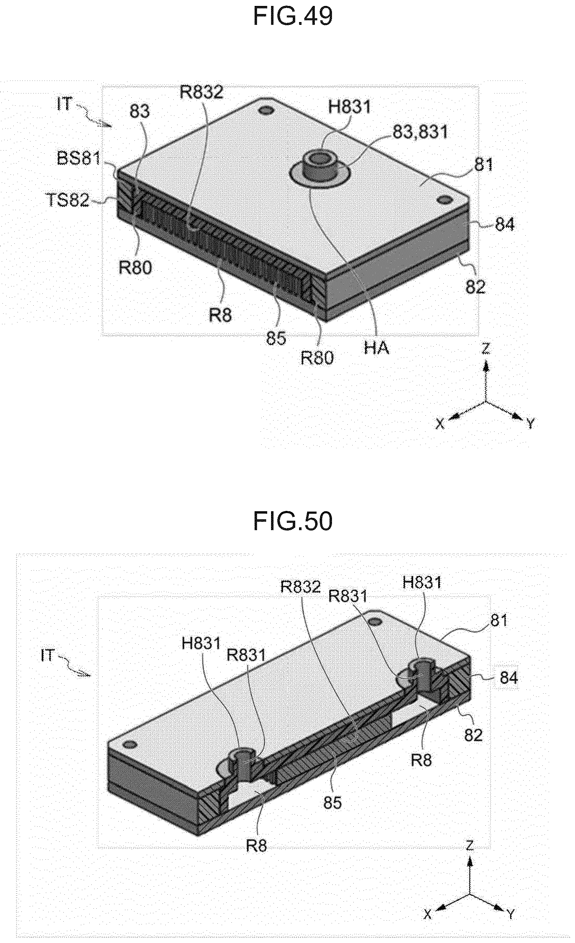

As illustrated in Fig. 47, the heat exchange device 1T includes a first metal plate 81, a second metal plate 82, a joint member 83, a resin fixing portion 84, and a partition member 85 (see Figs. 49 to 51).

The second metal plate 82, the partition member 85, the joint member 83, and the first metal plate 81 are disposed in this order. The resin fixing portion 84 is in contact with the peripheral edge portions of the first metal plate 81 and the second metal plate 82 thereby fixing the second metal plate 82 to the first metal plate 81.

The joint member 83 has a pair of coupling portions 831, each of which is coupled to an external supply unit or discharge unit to supply or discharge a cooling medium between the outside and the heat exchange device 1T.

In the eighteenth embodiment, a side on which one coupling portion 831 of the heat exchange device 1T is disposed is defined as a rear side of the heat exchange device 1T, and the opposite side is defined as a front side of the heat exchange device 1T. The right side when the heat exchange device 1T is viewed from the front side is defined as a right side of the heat exchange device 1T, and the opposite side is defined as a left side of the heat exchange device 1T. In the direction orthogonal to the front-rear direction and the left-right direction of the heat exchange device 1T, a side on which the first metal plate 81 is disposed is defined as an upper side of the heat exchange device 1T, and the opposite side is defined as a lower side of the heat exchange device 1T. Note that these orientations do not limit the orientation of the heat exchange device of the disclosure at the time of use.

In Figs. 47 to 51, the front side corresponds to a positive direction on an X-axis, the rear side corresponds to a negative direction on the X-axis, the right side corresponds to the positive direction on a Y-axis, the left side corresponds to the negative direction on the Y-axis, the upper side corresponds to the positive direction on a Z-axis, and the lower side corresponds to the negative direction on the Z-axis.

The heat exchange device 1T is of a plate type.

The heat exchange device 1T has an upper main surface TS1. The joint member 83 is disposed on the upper main surface TS1 side of the heat exchange device 1T. As illustrated in Fig. 48, the heat exchange device 1T has a lower main surface BS1. The lower main surface BS1 of the heat exchange device 1A has a planar shape.

An internal flow path R8 is formed inside the heat exchange device 1T. A cooling medium flows through the internal flow path R1. Examples of the cooling medium include those the same as those exemplified as the cooling medium according to the first embodiment.

The dimensions of the heat exchange device 1T are not particularly limited, and can be selected according to the application or the like of the heat exchange device 1T. For example, the dimension of the heat exchange device 1T may be similar to the dimension exemplified as the dimension of the heat exchange device 1A according to the first embodiment.

### (18.1) First Metal Plate

The first metal plate 81 is a flat plate-like object. The shape of the first metal plate 81 viewed from above to below is a substantially rectangular shape having a long side in the front-rear direction.

As illustrated in Fig. 47, the first metal plate 81 has a pair of through-holes HA. One through-hole HA is located at a rear center of the first metal plate 81, and the other through-hole HA is located at a front center of the first metal plate 81. The through-hole HA is an example of the through-hole.

The through-hole HA penetrates the first metal plate 81 along the vertical direction. The through-hole HA communicates with the internal flow path R8 (see Fig. 48) in the heat exchange device 1A.

The material of the first metal plate 81 is a metal, and may be the same as that exemplified as the material of the upper metal member 11A according to the first embodiment.

### (18.2) Second Metal Plate

The second metal plate 82 is a flat plate-like object. The shape of the second metal plate 82 viewed from above to below is a substantially rectangular shape having a long side in the front-rear direction.

The material of the second metal plate 82 is a metal, and may be the same as that exemplified as the material of the upper metal member 11A according to the first embodiment. The material of the second metal plate 82 may be the same as or different from the material of the first metal plate 81.

### (18.3) Joint Member

The joint member 83 is a plate-like object. An external supply unit and an external discharge unit are coupled to the joint member 83. The joint member 83 forms an internal flow path R8 (see Fig. 48) with the second metal plate 82 therebetween.

The coupling portion 831 is located on the upper surface side of the joint member 83. As illustrated in Figs. 49 and 50, the coupling portion 831 is exposed from the through-hole HA. The coupling portion 831 has an opening H831 and a hollow portion R831 (see Fig. 50).

The cooling medium is supplied to the opening H831. The opening H831 is located on the upper surface of the joint member 83. The opening portion H831 faces upward.

As illustrated in Fig. 50, the hollow portion R831 is formed to connect the opening H831 and the internal flow path R8. The hollow portion R831 is formed inside the one coupling portion 831.

The first metal plate 81 has a lower main surface BS81 (see Fig. 49). A portion of the upper surface of the joint member 83 surrounding at least the coupling portion 831 is in physical contact with the lower main surface BS81 of the first metal plate 81. Therefore, each of the pair of through-holes HA of the first metal plate 81 is closed by the joint member 83.

As illustrated in Figs. 49 and 50, the joint member 83 further has a recessed portion R832. The recessed portion R832 is located at a central portion in the front-rear and left-right directions on the lower surface side of the joint member 83.

The recessed portion R832 is formed for forming the internal flow path R8 through which the cooling medium flows with second metal plate 82 therebetween.

The second metal plate 82 has an upper main surface TS82 (see Fig. 49). A portion of the lower surface of the joint member 83 surrounding at least the recessed portion R832 is in physical contact with the upper main surface TS82 of the second metal plate 82. Therefore, the internal flow path R8 is formed between the recessed portion R832 and the upper main surface TS82 of the second metal plate.

The material of the joint member 83 is a resin, and may be the same as that exemplified as the resin constituting the joint member 20A according to the first embodiment.

### (18.4) Resin Fixing Portion

The resin fixing portion 84 fixes the second metal plate 82 to the first metal plate 81. That is, the resin fixing portion 84 integrates the first metal plate 81, the second metal plate 82, the joint member 83, and the partition member 85.

As illustrated in Fig. 49, a gap R80 is formed between the first metal plate 81 and the second metal plate 82. The gap R80 indicates a space between the first metal plate 81 and the second metal plate 82 where the joint member 83 is not in contact with the peripheral edge portions of the first metal plate 81 and the second metal plate 82. The gap R80 is formed over the entire periphery of the peripheral edge portions of the first metal plate 81 and the second metal plate 82.

The gap R80 is filled with the resin fixing portion 84. That is, the resin fixing portion 84 is in physical contact with the peripheral edge portion of the lower main surface BS81 of the first metal plate 81, the peripheral edge portion of the upper main surface TS82 of the second metal plate 82, and the side surface of the joint member 83.

Hereinafter, the surface of the first metal plate 81 in contact with the resin fixing portion 84 and the surface of the second metal plate 82 in contact with the resin fixing portion 84 are subjected to a roughening treatment in the same manner as in the first embodiment.

The resin fixing portion 84 is formed by injection molding. The material of the resin fixing portion 84 is a resin having compatibility with the resin constituting the joint member 83. Accordingly, the resin fixing portion 84 and the side surface of the joint member 83 are fused. In the disclosure, "having compatibility" indicates that the resin constituting resin fixing portion 84 is mixed without being separated in an atmosphere where the resin is melted. The main component of the resin constituting the resin fixing portion 84 is preferably the same as the resin constituting the joint member 83.

### (18.5) Partition Member

The partition member 85 partitions the internal flow path R8.

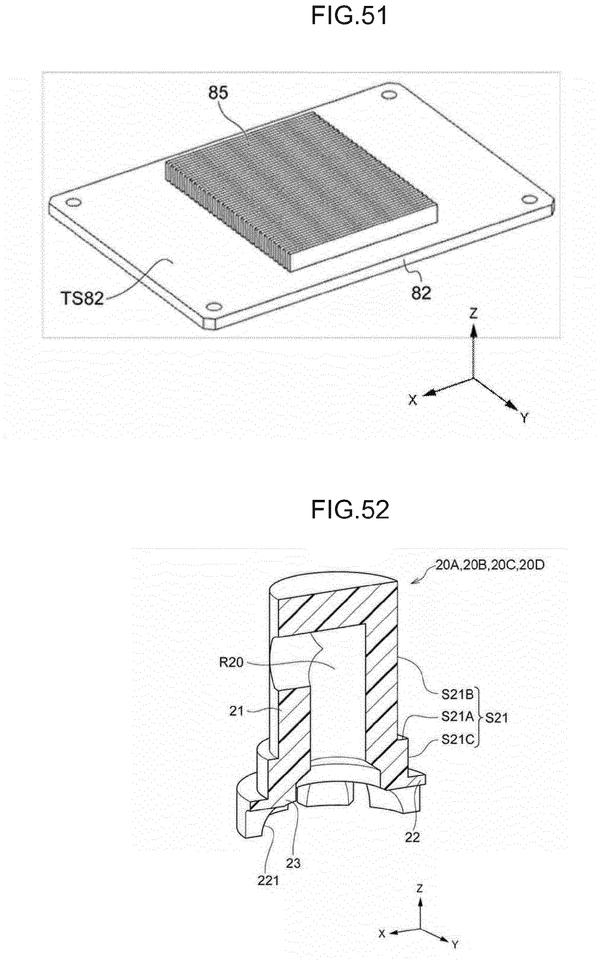

In the eighteenth embodiment, the partition member 85 has a plurality of partition wall portions. As illustrated in Fig. 51, the plurality of partition wall portions are disposed at predetermined intervals along the left-right direction. Each of the plurality of partition wall portions that is a long plate-like object controls the flow direction of the cooling medium.

The partition member 85 may be fixed to the second metal plate 82. The fixing method for fixing the partition member 85 to the second metal plate 82 is appropriately selected according to the material of the partition member 85. Examples of the fixing method include a method using a fastening component (hereinafter, referred to as "mechanical fastening"), welding, a method using an insert bonding layer, a method using a known adhesive, welding, and the like, and a plurality of these fixing methods can also be used in combination. The fastening component includes a bolt, a nut, a screw, a rivet, or a pin. The welding includes metal welding or brazing. The welding includes thermal welding, vibration welding, laser welding, ultrasonic welding, and hot plate welding.

The material of the partition member 85 is not particularly limited, and may be a resin or a metal, and may be the same as that exemplified as the material of the joint member 20A or the upper metal member 11A according to the first embodiment. The material of the partition member 85 may be the same as or different from the material of the second metal plate 82 or the joint member 83.

### (18.6) Flow of Cooling Medium

The heat exchange device 1T is installed and used such that, for example, the lower main surface BS1 of the heat exchange device 1T comes into contact with the heating element. At this time, an external supply unit is coupled to one coupling portion 831. An external discharge unit is coupled to the other coupling portion 831. The heat of the heating element is conducted to the cooling medium filled in the internal flow path R8 via at least one of the first metal plate 81 or the second metal plate 82.

The cooling medium is supplied to the opening H831 of the coupling portion 831. The cooling medium supplied to the opening H831 moves to the internal flow path R8 via the hollow portion R831 of the coupling portion 831. Most of the cooling medium moves toward the other coupling portion 831 in the internal flow path R8. At this time, the cooling medium exchanges heat with at least one of the first metal plate 81 or the second metal plate 82. Next, the cooling medium moves to the opening H831 via the hollow portion R831 of the other coupling portion 831, and is discharged to the external discharge unit. In this manner, the cooling medium absorbs heat from the heating element inside the heat exchange device 1T and is discharged to the outside of the heat exchange device 1T. That is, the heat exchange device 1T promotes heat dissipation of the heating element.

### (18.7) Action and Effect

As described with reference to Figs. 47 to 51, in the eighteenth embodiment, the heat exchange device 1T includes the first metal plate 81, the second metal plate 82, the pair of joint members 83, and the pair of resin fixing portions 84. The joint member 83 has a recessed portion R832, an opening H831, and a hollow portion R831.

As a result, the internal flow path R8 is formed even when the surrounding wall portion for forming the internal flow path R8 is not processed and molded on at least one of the first metal plate 81 or the second metal plate 82. The heat exchange device 1T can easily improve the degree of freedom in designing the internal flow path R8 by disposing the desired partition member 85 in the internal flow path R8.

As described with reference to Figs. 47 to 51, in the eighteenth embodiment, the heat exchange device IT further includes the partition member 85.

Accordingly, in the eighteenth aspect, the internal flow path R8 can be more freely designed.

As described with reference to Figs. 47 to 51, in the eighteenth embodiment, the gap R80 is formed between the first metal plate 81 and the second metal plate 82, and the resin fixing portion 84 is filled in the gap R80.

Accordingly, the heat exchange device 1T can more reliably maintain airtightness for a long period of time.

As described with reference to Figs. 47 to 51, in the eighteenth embodiment, the recessed portion R832 forms the internal flow path R8 with the second metal plate 82 therebetween.

Accordingly, in the eighteenth aspect, the internal flow path can be formed even when the joint member is not molded into a complicated structure.

As described with reference to Figs. 47 to 51, in the eighteenth embodiment, the surfaces of the first metal plate 81 and the second metal plate 82 in contact with the resin fixing portion 84 are subjected to the roughening treatment.

Accordingly, the surfaces of the first metal plate 81 and the second metal plate 82 in contact with the resin fixing portion 84 include fine unevenness. Accordingly, the resin fixing portion 84 is firmly fixed to the first metal plate 81 and the second metal plate 82 by the anchor effect as compared with a case where the roughening treatment is not performed. As a result, the heat exchange device 1T can maintain airtightness for a long period of time.

As described with reference to Figs. 47 to 51, in the eighteenth embodiment, the material of the joint member 83 is a resin, and the joint member 83 and the resin fixing portion 84 are fused.

Accordingly, the resin fixing portion 84 and the joint member 83 are firmly fixed to each other. As a result, the heat exchange device 1T can maintain airtightness for a longer period of time.

The embodiments of the invention have been described above with reference to the drawings. However, the invention is not limited to the above embodiments, and can be implemented in various aspects without departing from the gist thereof. For easy understanding, the drawings schematically illustrate each constituent element mainly, and the thickness, length, number, and the like of each illustrated constituent element are different from actual ones for convenience of drawing. In addition, the material, shape, dimension, and the like of each constituent element shown in the above embodiment are merely examples, and are not particularly limited, and various modifications can be made without substantially departing from the effects of the invention.

### (24) Modification

In the first to seventeenth embodiments, the joint member may not have the projecting portion.

In the first to seventeenth embodiments, at least one of the pair of sealing fixing surfaces or the joining fixing surface may not be subjected to the roughening treatment. The method for manufacturing the heat exchange device may not include at least one of the first roughening step or the second roughening step.

In the eighteenth embodiment, the second fixing surface may not be subjected to the roughening treatment.

In the first to seventeenth embodiments, the projecting portion may not have the notch portion.

In the first to seventeenth embodiments, the cross-sectional shape of the notch portion of the projecting portion may be a polygon. Examples of the polygon include a triangle, a quadrangle, a pentagon, a hexagon, and a heptagon. Examples of the triangle include an equilateral triangle, a right triangle, and an isosceles triangle. Examples of the quadrangle include a square, a rectangle, a parallelogram, and a trapezoid.

In the first to seventeenth embodiments, the resin sealing portion and the resin joint portion may be formed by transfer molding, compression molding, or cast molding. The resin joint portion may be an adhesive layer made of an adhesive.

In the eighteenth embodiment, the resin fixing portion may be formed by transfer molding, compression molding, or cast molding. The resin fixing portion may be an adhesive layer made of an adhesive.

In the first to eighteenth embodiments, a heating medium may be used as the heat exchange medium. Examples of the heating medium include a heating liquid and a heating gas. Examples of the heating liquid include water and oil. Examples of the heating gas include air and water vapor. The temperature of the heating medium is appropriately adjusted according to the type or the like of the heating element. When a heating medium is used as the heat exchange medium, the heat exchange device promotes heat storage of the external heating element.

In the first to seventeenth embodiments, the shape of the heat exchange device may be a double pipe type. Examples of the double pipe type include a coil shape and a U-tube shape. When the shape of the heat exchange device is a double pipe type, the shapes of the upper metal member and the lower metal member are appropriately adjusted according to the shape of the heat exchange device.

In the first to seventeenth embodiments, the heat exchange device may include two or more of one joint members and one resin sealing portions (hereinafter, referred to as a "supply member"), or may include two or more of the other joint members and the other resin sealing portions (hereinafter, referred to as a "discharge member").

In the eighteenth embodiment, the heat exchange device may include two or more of one through-holes and one coupling portions, or may include two or more of the other through-holes and the other coupling portions.

In the first to seventeenth embodiments, at least one of the supply member or the discharge member may be disposed on the side surface of the heat exchange device. One of the supply member and the discharge member may be disposed on the upper main surface side of the heat exchange device, and the other of the supply member and the discharge member may be disposed on the lower main surface side of the heat exchange device.

In the first to seventeenth embodiments, the heat exchange main body portion may not have the resin joint portion. When the heat exchange main body portion does not have the resin joint portion, for example, the upper metal member and the lower metal member may be joined by welding, brazing, or an adhesive. The heat exchange main body portion may have a metal member constituting the heat exchange main body portion in addition to the upper metal member and the lower metal member.

In the first to seventeenth embodiments, the material of the resin joint portion and the material of the resin sealing portion need not be the same.

In the first to eighteenth embodiments, the shape of each through-hole viewed from above to below need not be a circular shape or a substantially square shape. The shape of the through-hole may be a polygon (except for a substantially square shape). The shape of each of the pair of through-holes need not be the same.

In the first to seventeenth embodiments, the shape of the resin sealing portion viewed from above to below need not be a ring shape or a substantially square ring shape. For example, the shape of the resin sealing portion may be a polygonal ring shape (except for a substantially square ring shape). The shape of each of the pair of resin sealing portions need not be the same.

In the first to eighth embodiments, the shape of each of the protruding portion and the projecting portion viewed from above to below need not be a circular shape or a substantially square shape.

For example, the shape of each of the protruding portion and the projecting portion may be a polygon (except for a substantially square shape). The shape of each of the pair of protruding portions need not be the same. When the shape of the protruding portion is a polygon (except for a substantially square shape) and does not have a step surface, the radius of the inscribed circle of the protruding portion may be the same as the radius r22 (see Fig. 6) described in the first embodiment in a plane orthogonal to the vertical direction. When the shape of the protruding portion is a polygon (except for a substantially square shape) and has a step surface, the radius of the inscribed circle of the protruding portion may be the same as the radius r21C (see Fig. 11) described in the second embodiment on a plane orthogonal to the vertical direction. When the shape of the projecting portion is a polygon (except for a substantially square shape), the radius of the inscribed circle of the projecting portion may be the same as the radius r22 (see Fig. 6) described in the first embodiment in the plane orthogonal to the vertical direction.

In the first to eighth embodiments (except for the sixth embodiment), as shown in Fig. 51, the main body portion 23 may not have the contact surface S23 (see Fig. 6). Accordingly, the heat exchange device can further reduce the pressure loss of the cooling medium flowing through the internal flow path, and can cause the cooling medium to flow through the internal flow path more efficiently.

In the first to eighth embodiments (except for the sixth embodiment), the depth H221 of the notch portion 221 may be higher than half the height H22 (see Fig. 7) of the projecting portion 22. Accordingly, the heat exchange device can reduce the pressure loss of the cooling medium flowing through the internal flow path, and can cause the cooling medium to flow through the internal flow path more efficiently.

In the first to eighth embodiments, the number of notch portions of the projecting portion is not particularly limited, and may be seven or more, for example, twelve. Accordingly, the pressure loss of the cooling medium flowing through the internal flow path can be reduced as compared with the first embodiment, and the cooling medium can be caused to flow through the internal flow path more efficiently.

In the first to eighth embodiments, the material of the joint member may be a metal. The type of the metal constituting the joint member may be the same as that exemplified as the material of the upper metal member 11A, and may be the same as or different from the material of the upper metal member 11A. Accordingly, the joint member is less likely to be damaged than in a case of a resin, and airtightness can be maintained for a longer period of time.

A surface of the outer peripheral surface of the protruding portion, which is in contact with the resin sealing portion, is subjected to a roughening treatment in the same manner as the upper metal member, and includes fine unevenness.

Accordingly, the resin sealing portion is firmly fixed to the protruding portion by the anchor effect as compared with a case where the roughening treatment is not performed, and airtightness can be maintained for a longer period of time.

In the ninth to seventeenth embodiments, the shapes of the first connecting portion and the projecting portion viewed from above to below need not be circular or substantially square.

For example, the shape of each of the first connecting portion and the projecting portion may be a polygon (except for a substantially square shape). The shape of each of the pair of first connecting portions need not be the same. When the shape of the first connecting portion is a polygon (except for a substantially square shape), the radius of the inscribed circle of the first connecting portion may be the same as the radius r211B (see Fig. 29) described in the ninth embodiment in the plane orthogonal to the vertical direction. When the shape of the projecting portion is a polygon (except for a substantially square shape), the radius of the inscribed circle of the projecting portion may be the same as the radius r212 (see Fig. 29) described in the ninth embodiment in the plane orthogonal to the vertical direction.

In the first to seventeenth embodiments, the resin sealing portion and the resin joint portion may be formed in different steps in the sealing step.

In the first to eighth embodiments, the joint member need not be one of a resin molded body and a metal molded body. For example, when the outer peripheral surface of the protruding portion is made of a resin, the inside of the joint member may be a metal. When the outer peripheral surface of the protruding portion is made of a metal, the inside of the joint member may be a resin.

In the ninth to seventeenth embodiments, as long as the outer peripheral surface of the first connecting portion is made of a resin or a metal, the inside of the joint member may be made of a resin or a metal.

In the fourth embodiment and the thirteenth embodiment, the resin sealing portion may not have the filling portion. When the resin sealing portion does not have a filling portion, a gap between the projecting portion and the lower main surface of the upper metal member may be filled with an adhesive. The adhesive bonds the projecting portion and the upper metal member. Examples of the material of the adhesive include an epoxy resin, a silicone resin, an acrylic resin, and a urethane resin.

In the fifth embodiment and the fourteenth embodiment, the first covering portion and the second covering portion may not be integrated. The material of the first covering portion and the material of the second covering portion may be different from each other.

In the third embodiment and the ninth to seventeenth embodiments, the heat exchange device may not include the O-ring.

In the third embodiment and the ninth to seventeenth embodiments, the heat exchange device may include a packing different from the O-ring. Examples of the packing include a lip packing, a squeeze packing, an oil seal, a cushion seal, a dust seal, and a C-ring.

In the third embodiment and the ninth to seventeenth embodiments, the second component may not have the lid portion as long as the second component is connected to the first component.

In the eighteenth embodiment, the material of each of the joint member and the partition member may be a metal.

In the ninth to seventeenth embodiments, the material of the joint member may be a metal. The type of the metal can be selected according to the application or the like of the heat exchange device. The material of the joint member may be the same as or different from the material of the upper metal member.

The surface of the outer peripheral surface of the first connecting portion, which is in contact with the resin fixing portion, is subjected to a roughening treatment in the same manner as in the first embodiment, that is, includes fine unevenness on the contact surface. Therefore, by the anchor effect, the resin fixing portion is more firmly fixed to the first connecting portion than when the roughening treatment is not performed, and the airtightness can be maintained for a longer period of time.

In the eighteenth embodiment, the partition wall portion of the partition member 85 is a long plate-like object, but is not particularly limited as long as the partition member 85 can partition the internal flow path R8, and need not be a long plate-like object.

The disclosure of Japanese Patent Application No. 2020 -120925 filed on July 14, 2020 and the disclosure of Japanese Patent Application No. 2020-120926 filed on July 14, 2020 are incorporated herein by reference in their entirety.

All documents, patent applications, and technical standards described in this specification are incorporated herein by reference to the same extent as if each document, patent application, and technical standard were specifically and individually indicated to be incorporated by reference.

## Claims

1. A heat exchange device, comprising:
a heat exchange main body portion that has an internal flow path through which a heat exchange medium flows and a metal wall portion including a through-hole that communicates with the internal flow path;
a joint member that has a protruding portion including an opening through which the heat exchange medium is supplied or discharged and protruding toward an outside of the heat exchange main body portion via the through-hole, and a hollow portion for causing the opening and the internal flow path to communicate with each other; and
a resin sealing portion that seals a gap between an inner peripheral surface of the through-hole and an outer peripheral surface of the protruding portion.

2. A heat exchange device, comprising:
a heat exchange main body portion that has a metal wall portion including a through-hole;
a first component that covers the through-hole; and
a second component that is connected to the first component, wherein:
the heat exchange main body portion further has an internal flow path through which a heat exchange medium flows,
the first component has:
a first connecting portion including a first opening, and to which the second component is connected,
a first hollow portion for causing the first opening and the internal flow path to communicate with each other, and
a resin fixing portion that is fixed to the metal wall portion, and
the second component has:
a second connecting portion that includes a second opening through which the heat exchange medium is supplied or discharged, and to which a supply unit that supplies the heat exchange medium to the internal flow path or a discharge unit that discharges the heat exchange medium from the internal flow path is connected, and
a second hollow portion that causes the second opening and the first opening to communicate with each other.

3. The heat exchange device according to claim 2, further comprising:
a packing that seals a gap between the first component and the second component.

4. The heat exchange device according to claim 2 or 3, wherein:
the first component includes a joint member,
the joint member includes a protruding portion that is the first connecting portion and a hollow portion that is the first hollow portion,
the j oint member does not include a resin sealing portion that is the resin fixing portion,
the protruding portion protrudes toward an outside of the heat exchange main body portion via the through-hole, and
the resin sealing portion seals a gap between an inner peripheral surface of the through-hole and an outer peripheral surface of the protruding portion.

5. The heat exchange device according to claim 1 or 4, wherein:
the heat exchange main body portion has a facing wall portion facing the metal wall portion,
the joint member has a projecting portion that projects from the outer peripheral surface of the protruding portion over an entire periphery of the outer peripheral surface of the protruding portion, and
the projecting portion is in contact with an inner surface of the metal wall portion and an inner surface of the facing wall portion.

6. The heat exchange device according to any one of claims 1, 4, and 5, wherein a surface of the metal wall portion in contact with the resin sealing portion is subjected to a roughening treatment.

7. The heat exchange device according to any one of claims 1 and 4 to 6, wherein the resin sealing portion has a covering portion that covers a periphery of the through-hole on an outer surface of the metal wall portion.

8. The heat exchange device according to claim 7, wherein:
the joint member has a projecting portion that projects from the outer peripheral surface of the protruding portion over an entire periphery of the outer peripheral surface of the protruding portion, and
the covering portion has a first covering portion that covers a first region facing the projecting portion on the outer surface of the metal wall portion.

9. The heat exchange device according to claim 8, wherein the covering portion has a second covering portion that covers a second region outside the first region of the outer surface of the metal wall portion with respect to the through-hole.

10. The heat exchange device according to any one of claims 7 to 9, wherein:
the outer peripheral surface of the protruding portion has:
a distal end side outer peripheral surface,
a proximal end side outer peripheral surface having a diameter larger than that of the distal end side outer peripheral surface, and
a step surface that couples the distal end side outer peripheral surface and the proximal end side outer peripheral surface; and
the covering portion covers only the proximal end side outer peripheral surface of the outer peripheral surface of the protruding portion.

11. The heat exchange device according to any one of claims 5 to 10, wherein:
the heat exchange main body portion has a facing wall portion facing the metal wall portion,
the joint member has a projecting portion that projects from the outer peripheral surface of the protruding portion over an entire periphery of the outer peripheral surface of the protruding portion,
the projecting portion has a notch portion that forms a flow path between the notch and an inner surface of the facing wall portion, and
the flow path causes the hollow portion and the internal flow path to communicate with each other.

12. The heat exchange device according to claim 11, wherein a cross-sectional shape of the notch portion is an arch shape.

13. The heat exchange device according to any one of claims 1 and 4 to 12, wherein:
the outer peripheral surface of the protruding portion is made of a metal, and
a surface of the outer peripheral surface of the protruding portion in contact with the resin sealing portion is subjected to a roughening treatment.

14. The heat exchange device according to any one of claims 1 and 4 to 12, wherein:
the outer peripheral surface of the protruding portion is made of a resin, and
the outer peripheral surface of the protruding portion and the resin sealing portion are fused.

15. The heat exchange device according to any one of claims 1 and 4 to 14, wherein the resin sealing portion is formed by injection molding.

16. A method for manufacturing a heat exchange device, the method comprising:
a preparation step of preparing a joint member having a protruding portion;
an insert step of disposing the joint member inside a heat exchange main body portion having a metal wall portion including a through-hole and protruding the protruding portion toward an outside of the heat exchange main body portion via the through-hole; and
a sealing step of forming a resin sealing portion in a gap between an inner peripheral surface of the through-hole and an outer peripheral surface of the protruding portion and sealing the gap.

17. The method for manufacturing a heat exchange device according to claim 16, wherein:
the heat exchange main body portion has:
a pair of metal members facing each other, and
a resin joint portion that joins the pair of metal members;
one of the pair of metal members includes the metal wall portion; and
in the sealing step, the resin sealing portion is formed, and the resin joint portion is formed.

18. The method for manufacturing a heat exchange device according to claim 16 or 17, further comprising:
a roughening step of performing a roughening treatment on a surface of the metal wall portion with which the resin sealing portion is brought into contact,
wherein the roughening step is executed before the sealing step.
